(19) Europäisches Patentamt
European Patent Office
Office européen des brevets

(11) **EP 3 199 652 A2**

(12) **EUROPEAN PATENT APPLICATION**

(43) Date of publication:
**02.08.2017 Bulletin 2017/31**

(51) Int Cl.:
***C22C 9/02*** *(2006.01)*

(21) Application number: **17151569.5**

(22) Date of filing: **16.01.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **15.01.2016 JP 2016005644**

(71) Applicant: **JX Nippon Mining & Metals Corp.**
**Chiyoda-ku**
**Tokyo 1008164 (JP)**

(72) Inventor: **FUKUCHI, Ryo**
**Hitachi-shi, Ibaraki 317-0056 (JP)**

(74) Representative: **Yeadon IP Limited**
**Leeds Innovation Centre**
**103 Clarendon Road**
**Leeds LS2 9DF (GB)**

(54) **COPPER FOIL, COPPER-CLAD LAMINATE BOARD, METHOD FOR PRODUCING PRINTED WIRING BOARD, METHOD FOR PRODUCING ELECTRONIC APPARATUS, METHOD FOR PRODUCING TRANSMISSION CHANNEL, AND METHOD FOR PRODUCING ANTENNA**

(57)   To provide a copper foil and a copper-clad laminate board that have a good circuit formability and have a favorably suppressed transmission loss even in the use thereof in a high frequency circuit board. A copper foil comprising a gloss face, a surface roughness Ra of a surface of the copper foil on the gloss face side being 0.25 µm or less measured with a laser microscope and a surface roughness Rz of the surface of the copper foil on the gloss face side being 1.10 µm or less measured with a laser microscope, wherein the copper foil has a layer structure after heating at 200°C for 30 minutes or after heating at 130°C for 30 minutes or after heating at 300°C for 30 minutes.

Figure 1

EP 3 199 652 A2

**Description**

BACKGROUND OF THE INVENTION

Field of the Invention

The present invention relates to a copper foil, a copper-clad laminate board, a method for producing a printed wiring board, a method for producing an electronic apparatus, a method for producing a transmission channel, and a method for producing an antenna.

Related Art

Printed wiring boards have been largely developed over the recent half century, and now result in use in almost all electronic apparatuses. Following the recent increase of the demand of miniaturization and performance enhancement of electronic apparatuses, the enhancement of the mounting density of components and the increase of the signal frequency proceed, and the printed wiring boards are demanded to have an excellent capability under high frequency signals.

A high frequency substrate is demanded to have a reduced transmission loss for ensuring the quality of the output signal. The transmission loss is constituted mainly by a dielectric loss caused by a resin (i.e., a substrate) and a conductor loss caused by a conductor (i.e., a copper foil). The dielectric loss is decreased when the dielectric constant and the dielectric dissipation factor of the resin are decreased. The conductor loss in a high frequency signal is caused mainly in such a mechanism that the skin effect, in which an electric current having a higher frequency flows only a surface of a conductor, decreases the cross sectional area, through which an electric current flows, and thereby the resistance is increased. Accordingly, a high frequency circuit is necessarily formed with higher accuracy than the ordinary circuits, and excellent circuit formability is demanded.

As a technique for decreasing the transmission loss of the high frequency copper foil, for example, Patent Literature 1 describes a metal foil for a high frequency circuit containing a metal foil having coated on one surface or both surfaces thereof silver or a silver alloy, and having on the silver or silver alloy layer a coated layer formed in a thickness smaller than the silver or silver alloy layer. The literature describes that the metal foil can be provided that is reduced in loss due to the skin effect even in an ultrahigh frequency region used in satellite communications.

Patent Literature 2 describes a roughened rolled copper foil for a high frequency circuit, in which the integrated intensity ($I(200)$) of the (200) plane of the rolled surface of the rolled copper foil after recrystallization annealing obtained by X-ray diffraction is $I(200)/I_0(200) > 40$ with respect to the integrated intensity $I_0(200)$ of the (200) plane of fine powder copper obtained by X-ray diffraction, the arithmetic average roughness Ra of the roughened surface after performing a roughening treatment on the rolled surface by electrolytic plating is from 0.02 $\mu$m to 0.2 $\mu$m, the ten-point average roughness Rz is from 0.1 $\mu$m to 1.5 $\mu$m, and the copper foil is a material for a printed circuit board. The literature describes that a printed circuit board can be provided that is capable of being used under a high frequency exceeding 1 GHz.

Patent Literature 3 describes an electrolytic copper foil having on a part of the surface of the copper foil having an uneven surface having a surface roughness of from 2 to 4 $\mu$m formed of bumpy protrusions. The literature describes that an electrolytic copper foil can be provided that is excellent in high frequency wave transmission characteristics.

> Patent Literature 1: Japanese Patent No. 4,161,304
> Patent Literature 2: Japanese Patent No. 4,704,025
> Patent Literature 3: JP-A-2004-244656

As described in the foregoing, the conductor loss with a high frequency signal is mainly caused in such a mechanism that the cross sectional area of the conductor, through which an electric current flows, is decreased due to the skin effect, in which an electric current having a higher frequency flows only a surface of a conductor, and thereby the resistance is increased. The conductor loss is also caused by mismatch of the characteristic impedance, and therefore the copper foil is demanded to have the matching property of the characteristic impedance with the circuit, in addition to the reduction of the conductor loss. The present inventors have found that the deviation of the characteristic impedance of the circuit can be favorably suppressed by enhancing the circuit width accuracy, i.e., enhancing the circuit formability.

SUMMARY OF THE INVENTION

The invention has been made under the circumstances, and an object thereof is to provide a copper foil and a copper-clad laminate board that have a good circuit formability and have a favorably suppressed transmission loss even in the use thereof in a high frequency circuit board.

As a result of earnest investigations made by the present inventors for solving the problems, it has been found that the problems can be solved in such a manner that the roughness of the surface of the copper foil on the gloss face side is controlled to a prescribed manner, and even after subjecting the copper foil to the prescribed heating, the layer structure of the copper foil before heating is retained.

The invention has been achieved based on the knowledge, and relates to, in one aspect, a copper foil including a gloss face, a surface roughness Ra of a surface of the copper foil on the gloss face side being 0.25 $\mu$m or less measured with a laser microscope and a surface roughness Rz of the surface of the copper foil on the gloss face side being 1.10 $\mu$m or less measured with a laser microscope, in which the copper foil has a layer structure after heating at 200°C for 30 minutes or after heating at 130°C for 30 minutes or after heating at 300°C for 30 minutes.

The invention relates to, in another aspect, a copper foil including a gloss face, a surface roughness Ra of a surface of the copper foil on the gloss face side being 0.25 $\mu$m or less measured with a laser microscope of and a surface roughness Rz of a surface of the copper foil on the gloss face side being 1.10 $\mu$m or less measured with a laser microscope, in which the copper foil has a layer structure before heating at 200°C for 30 minutes or before heating at 130°C for 30 minutes, the layer structure being retained after the heating at 200°C for 30 minutes or after the heating at 130°C for 30 minutes.

The invention relates to, in still another aspect, a copper foil including a gloss face, a surface roughness Ra of a surface of the copper foil on the gloss face side being 0.25 $\mu$m or less measured with a laser microscope and a surface roughness Rz of a surface of the copper foil on the gloss face side being 1.10 $\mu$m or less measured with a laser microscope, in which the copper foil has $I(220)/I_0(220)$ of 1 or more of the surface of the copper foil on the gloss face side after heating the copper foil at 200°C for 30 minutes or after heating at 130°C for 30 minutes.

The invention relates to, in still another aspect, a copper foil including a gloss face, a surface roughness Ra of a surface of the copper foil on the gloss face side being 0.25 $\mu$m or less measured with a laser microscope and a surface roughness Rz of the surface of the copper foil on the gloss face side being 1.10 $\mu$m or less measured with a laser microscope, in which the copper foil has a layer structure after heating at 300°C for 30 minutes.

The invention relates to, in still another aspect, a copper foil including a gloss face, a surface roughness Ra of a surface of the copper foil on the gloss face side being 0.25 $\mu$m or less measured with a laser microscope and a surface roughness Rz of the surface of the copper foil on the gloss face side being 1.10 $\mu$m or less measured with a laser microscope, in which the copper foil has a layer structure before heating at 300°C for 30 minutes, the layer structure being retained after the heating at 300°C for 30 minutes.

The invention relates to, in still another aspect, a copper foil including a gloss face, a surface roughness Ra of a surface of the copper foil on the gloss face side being 0.25 $\mu$m or less measured with a laser microscope and a surface roughness Rz of the surface of the copper foil on the gloss face side being 1.10 $\mu$m or less measured with a laser microscope, in which the copper foil has $I(220)/I_0(220)$ of 1 or more of the surface of the copper foil on the gloss face side after heating the copper foil at 300°C for 30 minutes.

The invention relates to, in still another aspect, a copper foil comprising a gloss face, after heating at 200°C for 30 minutes or after the heating at 130°C for 30 minutes, and then half-etching with a sulfuric acid-hydrogen peroxide etching solution, a surface roughness Ra of a surface of the copper foil on the gloss face side being 0.22 $\mu$m or less measured with a laser microscope and a surface roughness Rz of the surface of the copper foil on the gloss face side being 1.30 $\mu$m or less measured with a laser microscope.

The invention relates to, in still another aspect, a copper foil including a gloss face, after heating at 300°C for 30 minutes, and then half-etching with a sulfuric acid-hydrogen peroxide etching solution, a surface roughness Ra of a surface of the copper foil on the gloss face side being 0.22 $\mu$m or less measured with a laser microscope and a surface roughness Rz of the surface of the copper foil on the gloss face side being 1.30 $\mu$m or less measured with a laser microscope.

The invention relates to, in still another aspect, a copper foil including a gloss face, after heating at 200°C for 30 minutes or after the heating at 130°C for 30 minutes, and then half-etching with a sulfuric acid-hydrogen peroxide etching solution, a surface roughness Ra of a surface of the copper foil on the gloss face side being 0.15 $\mu$m or less measured with a laser microscope and a surface roughness Rz of the surface of the copper foil on the gloss face side being 0.80 $\mu$m or less measured with a laser microscope.

The invention relates to, in still another aspect, a copper foil including a gloss face, after heating at 200°C for 30 minutes or after the heating at 130°C for 30 minutes, and then half-etching with a sodium persulfate etching solution, a surface roughness Ra of a surface of the copper foil on the gloss face side being 0.22 $\mu$m or less measured with a laser microscope and a surface roughness Rz of the surface of the copper foil on the gloss face side being 1.30 $\mu$m or less measured with a laser microscope.

The invention relates to, in still another aspect, a copper foil including a gloss face, after heating at 300°C for 30 minutes, and then half-etching with a sulfuric acid-hydrogen peroxide etching solution, a surface roughness Ra of a surface of the copper foil on the gloss face side being 0.15 $\mu$m or less measured with a laser microscope and a surface roughness Rz of the surface of the copper foil on the gloss face side being 0.80 $\mu$m or less measured with a laser microscope.

The invention relates to, in still another aspect, a copper foil including a gloss face, after heating at 300°C for 30 minutes, and then half-etching with a sodium persulfate etching solution, a surface roughness Ra of a surface of the copper foil on the gloss face side being 0.22 $\mu$m or less measured with a laser microscope and a surface roughness Rz of the surface of the copper foil on the gloss face side being 1.30 $\mu$m or less measured with a laser microscope.

In one embodiment of the copper foil according to the invention, a thickness of the copper foil that is removed by the half-etching is 6 $\mu$m or a half of a thickness before the half-etching.

In another embodiment of the copper foil according to the invention, the copper foil is a rolled copper foil.

In still another embodiment of the copper foil according to the invention, the copper foil is for attaching to a resin having a dielectric constant of 3.5 or less.

In still another embodiment of the copper foil according to the invention, the copper foil is for attaching to a liquid crystal polymer or a fluorine resin.

In still another embodiment of the copper foil according to the invention, the copper foil is used in a copper-clad laminate board or a printed wiring board that is used under a high frequency exceeding 1 GHz.

In still another embodiment of the copper foil according to the invention, the copper foil has $I(220)/I_0(220)$ of 1 or more of the surface of the copper foil on the gloss face side after the heating.

In still another embodiment of the copper foil according to the invention, the copper foil contains, on a surface of the copper foil, one or more layers selected from the group consisting of a roughening treatment layer, a heat resistance treatment layer, a rust prevention treatment layer, a chromate treatment layer, and a silane coupling treatment layer.

In still another embodiment of the copper foil according to the invention, the copper foil contains, on a surface of the copper foil, one or more layers selected from the group consisting of a heat resistance treatment layer, a rust prevention treatment layer, a chromate treatment layer, and a silane coupling treatment layer.

In still another embodiment of the copper foil according to the invention, the copper foil contains a heat resistance treatment layer or a rust prevention treatment layer on a surface of the copper foil, contains a chromate treatment layer on the heat resistance treatment layer or the rust prevention treatment layer, and contains a silane coupling treatment layer on the chromate treatment layer.

In still another embodiment of the copper foil according to the invention, the copper foil contains a heat resistance treatment layer on a surface of the copper foil, contains a rust prevention treatment layer on the heat resistance treatment layer, contains a chromate treatment layer on the rust prevention treatment layer, and contains a silane coupling treatment layer on the chromate treatment layer.

In still another embodiment of the copper foil according to the invention, the copper foil contains a chromate treatment layer on a surface of the copper foil, and contains a silane coupling treatment layer on the chromate treatment layer.

In still another embodiment of the copper foil according to the invention, the copper foil contains a roughening treatment layer on a surface of the copper foil, contains a chromate treatment layer on the roughening treatment layer, and contains a silane coupling treatment layer on the chromate treatment layer.

In still another embodiment of the copper foil according to the invention, the copper foil contains a roughening treatment layer on a surface of the copper foil, contains one or more layers selected from the group consisting of a rust prevention treatment layer and a heat resistance treatment layer on the roughening treatment layer, contains a chromate treatment layer on the one or more layers selected from the group consisting of a rust prevention treatment layer and a heat resistance treatment layer, and contains a silane coupling treatment layer on the chromate treatment layer.

In still another embodiment of the copper foil according to the invention, the copper foil contains a roughening treatment layer on a surface of the copper foil, contains a rust prevention treatment layer on the roughening treatment layer, contains a chromate treatment layer on the rust prevention treatment layer, and contains a silane coupling treatment layer on the chromate treatment layer.

In still another embodiment of the copper foil according to the invention, the copper foil contains a roughening treatment layer on a surface of the copper foil, and contains a silane coupling treatment layer on the roughening treatment layer.

In still another embodiment of the copper foil according to the invention, the copper foil contains a silane coupling treatment layer on a surface of the copper foil.

The invention relates to, in still another aspect, a copper-clad laminate board containing the copper foil according to the invention and an insulating substrate that are adhered to each other.

In one embodiment of the copper-clad laminate board according to the invention, the copper-clad laminate board is used under a high frequency exceeding 1 GHz.

The invention relates to, in still another aspect, a copper-clad laminate board including a copper foil and an insulating substrate that are adhered to each other, in which the copper foil has a layer structure, in which the copper foil has a gloss face, a surface roughness Ra of a surface of the copper foil on the gloss face side being 0.25 $\mu$m or less measured with a laser microscope and a surface roughness Rz of the surface of the copper foil on the gloss face side

being 1.10 μm or less measured with a laser microscope, and in which the copper-clad laminate board has a substrate dielectric constant of 3.5 or less.

The invention relates to, in still another aspect, a copper-clad laminate board including a copper foil and an insulating substrate that are adhered to each other, in which the copper foil has a gloss face, in which the copper foil has $I(220)/I_0(220)$ of 1 or more of a surface of the copper foil on the gloss face side after adhering to the insulating substrate, in which the copper foil has a surface roughness Ra of a surface of the copper foil on the gloss face side being 0.25 μm or less measured with a laser microscope and a surface roughness Rz of the surface of the copper foil on the gloss face side being 1.10 μm or less measured with a laser microscope, and in which the copper-clad laminate board has a substrate dielectric constant of 3.5 or less.

The invention relates to, in still another aspect, a copper-clad laminate board including a copper foil and an insulating substrate that are adhered to each other, in which the copper foil has a gloss face, after half-etching with a sulfuric acid-hydrogen peroxide etching solution, a surface roughness Ra of a surface of the copper foil on the gloss face side being 0.15 μm or less measured with a laser microscope and a surface roughness Rz of the surface of the copper foil on the gloss face side being measured with a laser microscope of 0.80 μm or less.

The invention relates to, in still another aspect, a copper-clad laminate board including a copper foil and an insulating substrate that are adhered to each other, in which the copper foil has a gloss face, after half-etching with a sodium persulfate etching solution, a surface roughness Ra of a surface of the copper foil on the gloss face side being 0.22 μm or less measured with a laser microscope and a surface roughness Rz of the surface of the copper foil on the gloss face side being 1.30 μm or less measured with a laser microscope.

The invention relates to, in still another aspect, a method for producing a printed wiring board, containing using the copper-clad laminate board according to the invention.

The invention relates to, in still another aspect, a method for producing an electronic apparatus, containing using a printed wiring board produced by the production method according to the invention.

The invention relates to, in still another aspect, a method for producing a transmission channel, containing using the copper-clad laminate board according to the invention or a printed wiring board produced by the production method according to the invention, the transmission channel being used under a high frequency exceeding 1 GHz.

The invention relates to, in still another aspect, a method for producing an antenna, containing using the copper-clad laminate board according to the invention or a printed wiring board produced by the production method according to the invention, the antenna being used under a high frequency exceeding 1 GHz.

According to the invention, a copper foil and a copper-clad laminate board can be provided that have a good circuit formability and have a favorably suppressed transmission loss even in the use thereof in a high frequency circuit board.

BRIEF DESCRIPTION OF THE DRAWING

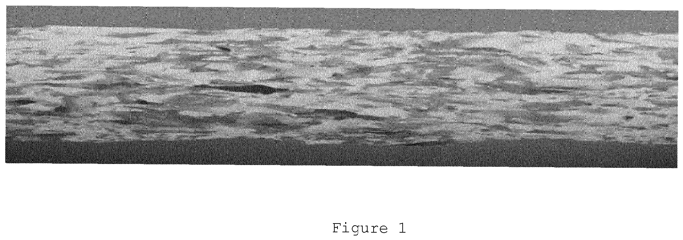

Fig. 1 is a cross sectional observation micrograph showing a layer structure of a copper foil.

DESCRIPTION OF THE EMBODIMENTS

The invention relates to, in one aspect, a copper foil including a gloss face, a surface roughness Ra of a surface of the copper foil on the gloss face side being 0.25 μm or less measured with a laser microscope and a surface roughness Rz of the surface of the copper foil on the gloss face side being 1.10 μm or less measured with a laser microscope, in which the copper foil has a layer structure after heating at 200°C for 30 minutes or after heating at 130°C for 30 minutes.

In the invention, the "gloss face" of the copper foil means a face of the copper foil that is opposite to a side of the copper foil to be laminated to a resin, or a face of the copper foil that is coated with an etching solution on forming a circuit pattern by etching.

The invention relates to, in another aspect, a copper foil including a gloss face, a surface roughness Ra of a surface of the copper foil on the gloss face side (on a surface on a gloss surface of the copper foil) being 0.25 μm or less measured with a laser microscope and a surface roughness Rz of the surface of the copper foil on the gloss face side (on the surface on a gloss surface of the copper foil) being 1.10 μm or less measured with a laser microscope, in which the copper foil has a layer structure before heating at 200°C for 30 minutes or before heating at 130°C for 30 minutes, the layer structure being retained after the heating at 200°C for 30 minutes or after the heating at 130°C for 30 minutes. The invention relates to, in still another aspect, a copper foil including a gloss face, a surface roughness Ra of a surface of the copper foil on the gloss face side being 0.25 μm or less measured with a laser microscope and a surface roughness Rz of the surface of the copper foil on the gloss face side being 1.10 μm or less measured with a laser microscope, in which the copper foil has $I(220)/I_0(220)$ of 1 or more of the surface of the copper foil on the gloss face side after heating the copper foil at 200°C for 30 minutes or after heating at 130°C for 30 minutes.

The invention relates to, in still another aspect, a copper foil including a gloss face, a surface roughness Ra of a surface of the copper foil on the gloss face side being 0.25 $\mu$m or less measured with a laser microscope and a surface roughness Rz of the surface of the copper foil on the gloss face side being 1.10 $\mu$m or less measured with a laser microscope, in which the copper foil has a layer structure after heating at 300°C for 30 minutes. The invention relates to, in still another aspect, a copper foil including a gloss face, a surface roughness Ra of a surface of the copper foil on the gloss face side being 0.25 $\mu$m or less measured with a laser microscope and a surface roughness Rz of the surface of the copper foil on the gloss face side being 1.10 $\mu$m or less measured with a laser microscope, in which the copper foil has a layer structure before heating at 300°C for 30 minutes, the layer structure being retained after the heating at 300°C for 30 minutes. The invention relates to, in still another aspect, a copper foil including a gloss face, a surface roughness Ra of a surface of the copper foil on the gloss face side being 0.25 $\mu$m or less measured with a laser microscope and a surface roughness Rz of the surface of the copper foil on the gloss face side being 1.10 $\mu$m or less measured with a laser microscope, in which the copper foil has $I(220)/I_0(220)$ of 1 or more on the surface of the copper foil on the gloss face side after heating the copper foil at 300°C for 30 minutes.

For the surface of the copper foil on the gloss face side, in the case where the surface roughness Ra (arithmetic average roughness) measured with a laser microscope is controlled to 0.25 $\mu$m or less and the surface roughness Rz (ten-point average roughness) measured with a laser microscope is controlled to 1.10 $\mu$m or less, in the thinning of the copper thickness of the copper foil on the gloss face side by a soft etching or half-etching process, the surface after the etching can be easily uniform or smooth, and thus the circuit formability on forming a circuit by etching can be improved, thereby forming a fine circuit with high accuracy. Accordingly, the impedance mismatch can be prevented from occurring, and the transmission loss can be favorably suppressed in the use thereof as a high frequency circuit.

For the surface of the copper foil on the gloss face side, the surface roughness Ra (arithmetic average roughness) measured with a laser microscope is preferably 0.25 $\mu$m or less, preferably 0.24 $\mu$m or less, preferably 0.20 $\mu$m or less, more preferably 0.15 $\mu$m or less, more preferably 0.14 $\mu$m or less, more preferably 0.13 $\mu$m or less, further preferably 0.10 $\mu$m or less, further preferably 0.09 $\mu$m or less, further preferably 0.08 $\mu$m or less, and further preferably 0.06 $\mu$m or less. The lower limit of the surface roughness Ra (arithmetic average roughness) measured with a laser microscope may not be necessarily determined, and is typically, for example 0.001 $\mu$m or more, for example 0.005 $\mu$m or more, for example 0.009 $\mu$m or more, for example 0.010 $\mu$m or more, and for example 0.015 $\mu$m or more.

For the surface of the copper foil on the gloss face side, the surface roughness Rz (ten-point average roughness) measured with a laser microscope is preferably 1.10 $\mu$m or less, more preferably 1.0 $\mu$m or less, more preferably 0.80 $\mu$m or less, further preferably 0.70 $\mu$m or less, further preferably 0.66 $\mu$m or less, further preferably 0.60 $\mu$m or less, further preferably 0.55 $\mu$m or less, further preferably 0.54 $\mu$m or less, and further preferably 0.50 $\mu$m or less. The lower limit of the surface roughness Rz (ten-point average roughness) measured with a laser microscope may not be necessarily determined, and is typically, for example 0.001 $\mu$m or more, for example 0.005 $\mu$m or more, for example 0.009 $\mu$m or more, for example 0.010 $\mu$m or more, for example 0.015 $\mu$m or more, for example 0.05 $\mu$m or more, for example 0.07 $\mu$m or more, and for example 0.09 $\mu$m or more.

For the surface of the copper foil on the gloss face side (the surface on the gloss surface of the copper foil), the surface roughness Ra (arithmetic average roughness) and the surface roughness Rz (ten-point average roughness) measured with a laser microscope can be controlled by the roughness of the rolling mill roll, the oil film equivalent amount, and the like in the rolling process in the production of the copper foil.

The oil film equivalent amount is shown by the following expression.

$$(\text{oil film equivalent amount}) = ((\text{viscosity of rolling oil (cSt)}) \times ((\text{rolling speed (mpm)}) + (\text{rolling peripheral velocity (mpm)})) / ((\text{bite angle of roll (rad)}) \times (\text{yield stress of material (kg/mm}^2))))$$

The viscosity of the rolling oil is the kinetic viscosity thereof at 40°C. For the surface of the copper foil on the gloss face side, the surface roughness Ra (arithmetic average roughness) and the surface roughness Rz (ten-point average roughness) measured with a laser microscope can be controlled by making the oil film equivalent amount into a range of from 12,000 to 42,000, preferably from 12,000 to 30,000, and preferably from 12,000 to 25,000. When the value of the oil film equivalent amount is decreased, there is a tendency that the values of the surface roughness Ra (arithmetic average roughness) and the surface roughness Rz (ten-point average roughness) are decreased, and when the value of the oil film equivalent amount is increased, there is a tendency that the values of the surface roughness Ra (arithmetic average roughness) and the surface roughness Rz (ten-point average roughness) are increased.

For making the oil film equivalent amount into a range of from 12,000 to 42,000, preferably from 12,000 to 30,000, and preferably from 12,000 to 25,000, known methods may be used, such as the use of a rolling oil having a low viscosity, the decrease of the rolling speed, and the like. The arithmetic average roughness Ra of the rolling mill roll (JIS B0601 1994) is preferably 0.20 μm or less.

The copper foil according to the aspect of the invention may have a layer structure, and as described above, when the copper foil is heated at 130°C for 30 minutes, at 200°C for 30 minutes, or at 300°C for 30 minutes, the layer structure (for example, a rolling fine layer structure in the rolled copper foil) before the heating is retained. The layer structure before the heating may not be necessarily retained completely, and may be partially recrystallized. The concept that "the layer structure before the heating is retained" includes the state that "even though the thickness, the size, and the shape of a part or the entirety of the crystal grains constituting the layer structure of the copper foil before the heating are changed by the heating, the copper foil still has the layer structure after the heating".

According to the constitution, in the case where the copper foil is subjected to etching for forming a circuit or half-etching for etching by approximately from 1/10 to 4/5 in the thickness thereof, the unevenness on the surface of the copper foil after the etching can be decreased, the circuit formability can be enhanced, and a fine circuit can be formed with high accuracy. Accordingly, the transmission loss can be favorably suppressed in the use thereof as a high frequency circuit.

In the invention, the "layer structure" means such a structure that in the observation of the cross section in parallel to the rolling direction in the rolled copper foil, or in the observation of the cross section in parallel to the traveling direction of the copper foil in the production of the electrolytic copper foil, long and thin crystal grains extending in the rolling direction or the traveling direction of the electrolytic copper foil are accumulated.

Before heating, or after heating at 130°C for 30 minutes, at 200°C for 30 minutes, or at 300°C for 30 minutes, the area ratio of the layer structure is preferably 5% or more in the observation of the cross section in parallel to the thickness direction of the copper foil and in parallel to the rolling direction in the rolled copper foil, or in the observation of the cross section in parallel to the thickness direction of the copper foil and in parallel to the traveling direction of the copper foil in the production of the electrolytic copper foil. In the case where the area ratio is 5% or more, when the copper foil is subjected to half-etching for etching by approximately from 1/10 to 4/5 in the thickness thereof, the unevenness on the surface of the copper foil after the etching can be further decreased in some cases, the circuit formability can be further enhanced in some cases, and a fine circuit can be formed with further high accuracy in some cases. The area ratio of the layer structure is preferably 10% or more, preferably 15% or more, preferably 20% or more, preferably 25% or more, preferably 30% or more, preferably 35% or more, preferably 40% or more, preferably 45% or more, preferably 50% or more, preferably 55% or more, preferably 60% or more, preferably 65% or more, preferably 70% or more, preferably 75% or more, preferably 80% or more, preferably 85% or more, preferably 90% or more, and more preferably 95% or more. The upper limit of the area ratio of the layer structure may not be necessarily determined, and is typically, for example 100% or less, for example 99.5% or less, for example 99% or less, and for example 98.5% or less.

In the case where the copper foil according to the aspect of the invention is subjected to heating at 130°C for 30 minutes, at 200°C for 30 minutes, or at 300°C for 30 minutes, the layer structure thereof before the heating is retained, and the retention of the layer structure can be controlled by suppressing the recrystallized structure from being formed, by decreasing the rolling reduction in the rolling process in the production of the copper foil, or by adding an element except for Cu, such as Sn, or one or more elements selected from the group consisting of Sn, Ag, In, Au, Pd, P, Ti, B, V, Cr, Fe, Zr, Mn, Mo, Co, Ni, Zn, Si, C, W, As, Ca, Al, Cl, Be, N, S, F, Sr, Ba, Sc, Y, Ga, Ge, Se, Br, Nb, Ta, Ru, Rh, Cd, Sb, Bi, I, and Mg, as an additional metal or an additional element of the components of the copper foil. The concentration of the additional element in the copper foil in terms of the total amount of the one or more elements selected from the group consisting of Sn, Ag, In, Au, Pd, P, Ti, B, V, Cr, Fe, Zr, Mn, Mo, Co, Ni, Zn, Si, C, W, As, Ca, Al, Cl, Be, N, S, F, Sr, Ba, Sc, Y, Ga, Ge, Se, Br, Nb, Ta, Ru, Rh, Cd, Sb, Bi, I, and Mg is preferably 10 ppm by mass or more, preferably 20 ppm by mass or more, preferably 30 ppm by mass or more, preferably 50 ppm by mass or more, preferably 100 ppm by mass or more, preferably 200 ppm by mass or more, preferably 300 ppm by mass or more, preferably 500 ppm by mass or more, preferably 700 ppm by mass or more, preferably 900 ppm by mass or more, and preferably 1,100 ppm by mass or more. The upper limit of the concentration of the additional element in the copper foil may not be necessarily determined, and is typically, for example 50% by mass or less, for example 40% by mass or less, for example 30% by mass or less, for example 20% by mass or less, for example 10% by mass or less, for example 1% by mass or less, for example 0.50% by mass or less, for example 0.45% by mass or less, and for example 0.40% by mass or less.

In the case where the value $I(220)/I_0(220)$ on the surface of the copper foil on the gloss face side is 1 or more after heating the copper foil under the aforementioned conditions, such an effect may be obtained that a smooth surface can be easily obtained after half-etching. It is considered that the value $I(220)/I_0(220)$ of 1 or more means that a large proportion of the crystal grains has the (220) planes that are oriented parallel to the surface of the copper foil. It can be expected that the (220) plane has a smaller packing frequency of Cu atoms than the other crystal planes, and the (220) plane is easily etched. Accordingly, it can be expected that the effect is obtained since the proportion of the crystal grains that are oriented parallel to the surface of the copper foil in the (220) plane which is easily etched is large. The value $I(220)/I_0(220)$ on the surface of the copper foil on the gloss face side may be 2 or more, 3 or more, 3.3 or more, 4 or more, 5 or more 6 or more, 7 or more, 8 or more, or 9 or more. The value $I(220)/I_0(220)$ on the surface of the copper foil on the gloss face side can be controlled by suppressing the recrystallized structure from being formed, by decreasing the rolling reduction in the rolling process in the production of the copper foil, or by adding an element except for Cu, such as Sn, or one or more elements selected from the group consisting of Sn, Ag, In, Au, Pd, P, Ti, B, V, Cr, Fe, Zr, Mn, Mo, Co, Ni, Zn, Si, C, W, As, Ca, Al, Cl, Be, N, S, F, Sr, Ba, Sc, Y, Ga, Ge, Se, Br, Nb, Ta, Ru, Rh, Cd, Sb, Bi, I, and Mg, as an additional metal or an additional element of the components of the copper foil. The concentration of the additional element in the copper foil in terms of the total amount of the one or more elements selected from the group consisting of Sn, Ag, In, Au, Pd, P, Ti, B, V, Cr, Fe, Zr, Mn, Mo, Co, Ni, Zn, Si, C, W, As, Ca, Al, Cl, Be, N, S, F, Sr, Ba, Sc, Y, Ga, Ge, Se, Br, Nb, Ta, Ru, Rh, Cd, Sb, Bi, I, and Mg is preferably 10 ppm by mass or more, preferably 20 ppm by mass or more, preferably 30 ppm by mass or more, preferably 50 ppm by mass or more, preferably 100 ppm by mass or more, preferably 200 ppm by mass or more, preferably 300 ppm by mass or more, preferably 500 ppm by mass or more, preferably 700 ppm by mass or more, preferably 900 ppm by mass or more, and preferably 1,100 ppm by mass or more. The upper limit of the concentration of the additional element in the copper foil may not be necessarily determined, and is typically, for example 50% by mass or less, for example 40% by mass or less, for example 30% by mass or less, for example 20% by mass or less, and for example 10% by mass or less.

The average thickness of the crystal grains of the copper foil is preferably 1.0 $\mu$m or less. In the case where the average thickness of the crystal grains of the copper foil is 1.0 $\mu$m or less, such an effect may be obtained that the surface of the copper foil can be easily a smooth surface after half-etching. The average thickness of the crystal grains of the copper foil is more preferably 0.8 $\mu$m or less, more preferably 0.7 $\mu$m or less, more preferably 0.6 $\mu$m or less, more preferably 0.5 $\mu$m or less, more preferably 0.4 $\mu$m or less, more preferably 0.38 $\mu$m or less, and more preferably 0.35 $\mu$m or less. The lower limit of the average thickness of the crystal grains of the copper foil may not be necessarily determined, and is typically, for example 0.001 $\mu$m or more, for example 0.01 $\mu$m or more, for example 0.02 $\mu$m or more, and for example 0.03 $\mu$m or more. With regard to the average thickness of the crystal grains of the copper foil, it is preferable to control the average thickness of the crystal grains of the copper foil before heating at 130°C for 30 minutes or at 200°C for 30 minutes or at 300°C for 30 minutes, and/or, after heating at 130°C for 30 minutes or at 200°C for 30 minutes or at 300°C for 30 minutes.

The average thickness of the crystal grains of the copper foil in the case where the copper foil is a rolled copper foil can be decreased by decreasing the average crystal grain size on the cross section in parallel to the rolling direction of the copper foil and in parallel to the thickness direction thereof before the final cold rolling, and/or increasing the final cold rolling reduction, and/or increasing the oil film equivalent amount in the final cold rolling, and/or increasing the concentration of the additional element except for Cu in the copper foil. The additional element except for Cu used may be the aforementioned additional elements. The concentration of the additional element except for Cu in the copper foil may be the aforementioned concentrations. The average thickness of the crystal grains of the copper foil in the case where the copper foil is a rolled copper foil can be increased by increasing the average crystal grain size (the average grain size) on the cross section in parallel to the rolling direction of the copper foil and in parallel to the thickness direction thereof before the final cold rolling, and/or decreasing the final cold rolling reduction, and/or decreasing the oil film equivalent amount in the final cold rolling, and/or decreasing the concentration of the additional element except for Cu in the copper foil. In the case where the copper foil is an electrolytic copper foil, the average thickness of the crystal grains of the copper foil can be controlled by adding an additive that accelerates growth of crystal grains in the plane direction of the copper foil and suppresses growth of crystal grains in the thickness direction thereof, to the electrolytic solution used in the production of the electrolytic copper foil. In the case where the copper foil is an electrolytic copper foil, when the copper foil is formed by repeating the operation of copper plating and water rinsing and/or drying, the average thickness of the crystal grains of the copper foil can be controlled by controlling the thickness of copper plating, for example, to 1.0 $\mu$m or less in each of the operations. In the case where the copper foil is a copper foil formed by dry plating, when the copper foil is formed by providing plural dry copper plating layers that are different in components contained, the average thickness of the crystal grains of the copper foil can be controlled by controlling the thickness of copper plating, for example, to 1.0 $\mu$m or less in each of the dry copper plating layers that are different in components contained.

The reduction in the final cold rolling may be from 80 to 99.0%. The oil film equivalent amount in the final cold rolling may be from 12,000 to 42,000.

The average crystal grain size of the copper foil before the final cold rolling can be decreased by decreasing the heating temperature in the annealing of the copper foil before the final cold rolling and/or decreasing the heating time therein. The average crystal grain size of the copper foil before the final cold rolling can be increased by increasing the heating temperature in the annealing of the copper foil before the final cold rolling and/or increasing the heating time therein.

The heating temperature in the annealing before the final cold rolling may be from 300 to 900°C. The heating time in the annealing before the final cold rolling may be from 0.1 second to 10 hours.

The average crystal grain size on the cross section in parallel to the rolling direction of the copper foil and in parallel to the thickness direction thereof before the final cold rolling may be from 2.0 to 18.0 $\mu$m. In the case where the average crystal grain size on the cross section in parallel to the rolling direction of the copper foil and in parallel to the thickness direction thereof before the final cold rolling is less than 2.0 $\mu$m, a large amount of the stress due to the final cold rolling may be accumulated in the copper foil, and thus the metal structure of the copper foil may be a recrystallized structure in some cases on heating the copper foil.

The rolling reduction is shown by the following expression.

$$\text{(rolling reduction (\%))} = (t_0 - t)/t_0 \times 100 \text{ (\%)}$$

wherein to represents the thickness before rolling, and t represents the thickness after rolling.

The copper foil to be subjected to the surface treatment that can be used in the invention (i.e., the raw foil, the copper foil that is not subjected to the surface treatment, or the copper foil before the surface treatment) is not particularly limited in the kind thereof, and a rolled copper foil and an electrolytic copper foil can be preferably used. A rolled copper foil is particularly effectively used since the layer structure can be easily provided. In the case where a rolled copper foil is used, the layer structure has, for example, a rolled fine layer structure. The copper foil includes a pure copper foil and a copper alloy foil, and any known arbitrary composition of a copper foil for the purpose of forming a circuit may be used. Examples of the material of the copper foil that can be used in the invention include a high purity copper that is generally used as a conductor pattern of a printed wiring board, such as a tough pitch copper (JIS H3100, alloy number: C1100), an oxygen-free copper (JIS H3100, alloy number: C1020, or JIS H3510, alloy number: C1011), a phosphorus-deoxidized copper (JIS H3100, alloy number: C1201, C1220, or C1221), and an electrolytic copper, and also include a copper alloy, such as a Sn-containing copper, an Ag-containing copper, a copper alloy containing Cr, Zr, Mg, or the like, and a Corson copper alloy containing Ni, Si, and the like. In the description herein, examples of the copper foil in the case where the term "copper alloy" is solely used include a copper alloy foil. The copper foil that can be used in the invention may contain one or more elements selected from the group consisting of Sn, Ag, In, Au, Pd, P, Ti, B, V, Cr, Fe, Zr, Mn, Mo, Co, Ni, Zn, Si, C, W, As, Ca, Al, Cl, Be, N, S, F, Sr, Ba, Sc, Y, Ga, Ge, Se, Br, Nb, Ta, Ru, Rh, Cd, Sb, Bi, I, and Mg. The copper foil that can be used in the invention may contain one or more elements selected from the group consisting of Sn, Ag, In, Au, Pd, P, Ti, B, V, Cr, Fe, Zr, Mn, Mo, Co, Ni, Zn, Si, C, W, As, Ca, Al, Cl, Be, N, S, F, Sr, Ba, Sc, Y, Ga, Ge, Se, Br, Nb, Ta, Ru, Rh, Cd, Sb, Bi, I, and Mg in a total amount of 0% by mass or more and 20% by mass or less, preferably 0.0001% by mass or more and 10% by mass or less, preferably 0.001% by mass or more and 10% by mass or less, preferably 0.05% by mass or more and 10% by mass or less, and more preferably 0.08% by mass or more and 5% by mass or less.

The thickness of the copper foil is not particularly limited, and may be, for example, from 1 to 1,000 $\mu$m, from 1 to 500 $\mu$m, from 1 to 300 $\mu$m, from 3 to 100 $\mu$m, from 5 to 70 $\mu$m, from 6 to 35 $\mu$m, or from 9 to 18 $\mu$m.

The copper foil that can be used in the invention may be an ultrathin copper layer of a copper foil having a carrier containing a carrier, a release layer, and an ultrathin copper layer in this order, and the copper foil may have a carrier. The copper foil having a carrier, and the carrier may be any kind of a copper foil having a carrier, and a carrier, respectively, and a known copper foil having a carrier, and a known carrier may be used.

In one embodiment, the copper foil according to the aspect of the invention may contain, on a surface of the copper foil, one or more layers selected from the group consisting of one or more roughening treatment layer(s), one or more heat resistance treatment layer(s), one or more rust prevention treatment layer(s), one or more chromate treatment layer(s), and one or more silane coupling treatment layer(s). In one embodiment, the copper foil according to the aspect of the invention may contain, on a surface of the copper foil, one or more layers selected from the group consisting of a heat resistance treatment layer, a rust prevention treatment layer, a chromate treatment layer, and a silane coupling treatment layer.

The roughening treatment layer is not particularly limited, and any of roughening treatment layers and the known roughening treatment layers may be applied thereto. The heat resistance treatment layer is not particularly limited, and any of heat resistance treatment layers and the known heat resistance treatment layers may be applied thereto. The rust prevention treatment layer is not particularly limited, and any of rust prevention treatment layers and the known rust prevention treatment layers may be applied thereto. The chromate treatment layer is not particularly limited, and any of chromate treatment layers and the known chromate treatment layers may be applied thereto. The silane coupling treatment layer is not particularly limited, and any of silane coupling treatment layers and the known silane coupling treatment layers may be applied thereto.

In one embodiment, the copper foil according to the aspect of the invention may contain, on a surface of the copper foil, one or more roughening treatment layer(s) by subjecting the surface to a roughening treatment, for example, for enhancing the adhesiveness to an insulating substrate, and the like. The roughening treatment may be performed, for example, by forming roughening particles with copper or a copper alloy. The roughening treatment layer may be one or more layer(s) formed of an elementary substance selected from the group consisting of copper, nickel, phosphorus, tungsten, arsenic, molybdenum, chromium, cobalt, and zinc, or an alloy containing one or more selected from the group, or the like. Roughening particles may be formed with copper or a copper alloy, and then a roughening treatment may further be performed by providing secondary particles or tertiary particles with an elementary substance or an alloy of nickel, cobalt, copper, or zinc, or the like. In particular, such a roughening treatment layer is preferred that contains a primary particle layer of copper, and a secondary particle layer formed of a ternary alloy of copper, cobalt, and nickel, formed on the primary particle layer.

In one embodiment of the copper foil according to the aspect of the invention, after performing the roughening treatment, one or more heat resistance treatment layer (s) or one or more rust prevention treatment layer(s) may be formed with an elementary substance or an alloy of nickel, cobalt, copper, or zinc, or the like, and one or more chromate treatment, one or more silane coupling treatment, and the like may be further performed on the surface of the heat resistance treatment layer(s) or the rust prevention treatment layer(s). In alternative, without performing the roughening treatment, one or more heat resistance treatment layer(s) or one or more rust prevention treatment layer (s) may be formed with one element selected from a group consisting of nickel, cobalt, copper and zinc or an alloy of nickel, cobalt, copper, or zinc, or the like, and one or more chromate treatment, one or more silane coupling treatment, and the like may be further performed on the surface of the heat resistance treatment layer(s) or the rust prevention treatment layer(s).

Specifically, one or more layers selected from the group consisting of a heat resistance treatment layer, a rust prevention treatment layer, a chromate treatment layer, and a silane coupling treatment layer may be formed on the surface of the roughening treatment layer, and one or more layers selected from the group consisting of a heat resistance treatment layer, a rust prevention treatment layer, a chromate treatment layer, and a silane coupling treatment layer may be formed on the surface of the copper foil. The heat resistance treatment layer, the rust prevention treatment layer, the chromate treatment layer, and the silane coupling treatment layer each may be formed of plural layers (for example, two or more layers, or three or more layers). In the aspect of the invention, the "rust prevention treatment layer" includes the "chromate treatment layer". In consideration of the adhesiveness to a resin, a silane coupling treatment layer is preferably provided as the outermost layer of the copper foil.

Examples of the rust prevention treatment layer or the chromate treatment layer used include the following treatments.

Ni Plating

    Composition of solution: Ni ion: 10 to 40 g/L pH: 1.0 to 5.0
    Temperature of solution: 30 to 70°C
    Current density: 1 to 9 A/dm$^2$
    Energizing time: 0.1 to 3 sec

Ni-Co Plating (Ni-Co Alloy Plating)

    Composition of solution: Co: 1 to 20 g/L, Ni: 1 to 20 g/L pH: 1.5 to 3.5
    Temperature of solution: 30 to 80°C
    Current density: 1 to 20 A/dm$^2$
    Energizing time: 0.5 to 4 sec

Zn-Ni Plating (Zn-Ni Alloy Plating)

    Composition of solution: Zn: 10 to 30 g/L, Ni: 1 to 10 g/L pH: 3 to 4
    Temperature of solution: 40 to 50°C
    Current density: 0.5 to 5 A/dm$^2$
    Energizing time: 1 to 3 sec

Ni-Mo Plating (Ni-Mo Alloy Plating)

Composition of solution: nickel sulfate: 270 to 280 g/L, nickel chloride: 35 to 45 g/L, nickel acetate: 10 to 20 g/L, molybdenum (added as sodium molybdate): 0.1 to 10 g/L, trisodium citrate: 15 to 25 g/L, gloss agent: saccharin, butynediol, or the like, sodium dodecyl sulfate: 55 to 75 ppm

pH: 4 to 6
Temperature of solution: 55 to 65°C
Current density: 1 to 11 A/dm$^2$
Energizing time: 1 to 20 sec

Cu-Zn Plating (Cu-Zn Alloy Plating)

Composition of solution: NaCN: 10 to 30 g/L, NaOH: 40 to 100 g/L, Cu: 60 to 120 g/L, Zn: 1 to 10 g/L
Temperature of solution: 60 to 80°C
Current density: 1 to 10 A/dm$^2$
Energizing time: 1 to 10 sec

Electrolytic Chromate

Composition of solution: chromic anhydride, chromic acid, or potassium bichromate: 1 to 10 g/L, zinc (added as zinc sulfate when added): 0 to 5 g/L
pH: 0.5 to 10
Temperature of solution: 40 to 60°C
Current density: 0.1 to 2.6 A/dm$^2$
Coulomb amount: 0.5 to 90 As/dm$^2$
Energizing time: 1 to 30 sec

Immersion Chromate

Composition of solution: chromic anhydride, chromic acid, or potassium bichromate: 1 to 10 g/L, zinc (added as zinc sulfate when added): 0 to 5 g/L
pH: 2 to 10
Temperature of solution: 20 to 60°C
Treatment time: 1 to 30 sec

The silane coupling agent used in the silane coupling treatment for forming the silane coupling treatment layer may be a known silane coupling agent, and examples thereof used include an amino silane coupling agent, an epoxy silane coupling agent, and a mercapto silane coupling agent. Examples of the silane coupling agent include vinyltrimethoxysilane, vinylphenyltrimethoxysilane, γ-methacryloxypropyltrimethoxysilane, γ-glycidoxypropyltrimethoxysilane, 4-glycidylbutyltrimethoxysilane, γ-aminopropyltriethoxysilane, N-β-(aminoethyl)-γ-aminopropyltrimethoxysilane, N-3-(4-(3-aminopropoxy)butoxy)propyl)-3-aminopropyltrimethoxysilane, imidazole silane, triazine silane, and γ-mercaptopropyltrimethoxysilane.
The silane coupling treatment layer may be formed by using a silane coupling agent, such as an epoxy silane, an amino silane, a methacryloxy silane, and a mercapto silane. The silane coupling agents may be used solely or as a mixture of two or more kinds thereof. Among these, the silane coupling treatment layer is preferably formed by using an amino silane coupling agent or an epoxy silane coupling agent.
The amino silane coupling agent used herein may be selected from the group consisting of N-(2-aminoethyl)-3-aminopropyltrimethoxysilane, 3-(N-stylylmethyl-2-aminoethylamino)propyltrimethoxysilane, 3-aminopropyltriethoxysilane, bis(2-hydroxyethyl)-3-aminopropyltriethoxysilane, aminopropyltrimethoxysilane, N-methylaminopropyltrimethoxysilane, N-phenylaminopropyltrimethoxysilane, N-(3-acryloxy-2-hydroxypropyl)-3-aminopropyltriethoxysilane, 4-aminobutyltriethoxysilane, (aminoethylaminomethyl)phenethyltrimethoxysilane, N-(2-aminoethyl-3-aminopropyl)trimethoxysilane, N-(2-aminoethyl-3-aminopropyl)tris(2-ethylhexoxy)silane, 6-(aminohexylaminopropyl)trimethoxysilane, aminophenyltrimethoxysilane, 3-(1-aminopropoxy)-3,3-dimethyl-1-propenyltrimethoxysilane, 3-aminopropyltris(methoxyethoxyethoxy)silane, 3-aminopropyltriethoxysilane, 3-aminopropyltrimethoxysilane, ω-aminoundecyltrimethoxysilane, 3-(2-N-benzylaminoethylaminopropyl)trimethoxysilane, bis(2-hydroxyethyl)-3-aminopropyltriethoxysilane, (N,N-diethyl-3-aminopropyl)trimethoxysilane, (N,N-dimethyl-3-aminopropyl)trimethoxysilane, N-methylaminopropyltrimethoxysilane, N-phenylaminopropyltrimethoxysilane, 3-(N-stylylmethyl-2-aminoethylamino)propyltrimethoxysilane, γ-aminopropyltriethoxysilane, N-β-(aminoethyl)-γ-aminopropyltrimethoxysilane, and N-3-(4-(3-aminopropoxy)butoxy)propyl-3-aminopropyltrimethoxysilane.

The silane coupling treatment layer is preferably provided in an amount in terms of silicon atoms in a range of from 0.05 to 200 mg/m$^2$, preferably from 0.15 to 20 mg/m$^2$, and preferably from 0.3 to 2.0 mg/m$^2$. In the case where the amount thereof is in the range, the adhesiveness between an insulating substrate and the copper foil can be enhanced.

A copper-clad laminate board can be formed by adhering the copper foil according to the aspect of the invention to an insulating substrate. The copper-clad laminate board may be a single layer copper-clad laminate board containing an insulating substrate having a single layer structure, or a multilayer copper-clad laminate board containing two or more layers of insulating substrates. The copper-clad laminate board may be a flexible board or a rigid board. The insulating substrate is not particularly limited, and examples thereof include insulating substrates formed of an epoxy resin, a phenol resin, a polyimide resin, a polyamideimide resin, a polyester resin, a polyphenylene sulfide resin, a polyether imide resin, a fluorine resin, a liquid crystal polymer (LCP), and mixtures thereof. Examples of the insulating substrate also include an insulating substrate formed of a glass cloth impregnated with an epoxy resin, a bismaleimide triazine resin, a polyimide resin, or the like. A publicly known insulating substrate may be used as the insulating substrate. Among these, a liquid crystal polymer or a fluorine resin or a low induction polyimide resin are suitable for a purpose under a high frequency due to the remarkable advantages thereof including a low dielectric constant, a low dielectric dissipation factor, a low water absorbing property, and a small change in electric characteristics, and further including a small dimensional change. The copper foil according to the aspect of the invention is useful as a copper foil for a flexible printed circuit board (FPC) that contains a liquid crystal polymer or a fluorine resin or a low induction polyimide resin having a copper foil laminated thereon. The copper-clad laminate board according to the aspect of the invention has good circuit formability, has a copper foil having a transmission loss that is favorably suppressed in the use thereof in a high frequency circuit board, and is particularly effective in an application under a high frequency exceeding 1 GHz.

In the description herein, a polyimide resin having a dissipation factor of 0.01 or less is referred to as a low induction polyimide resin. The dissipation factor can be measured according to JPCA-TM001-2007 "Test method for copper-clad laminates for printed wiring boards dielectric constant and dissipation factor" by Japan Electronics Packaging and Circuits Association, by the triplate resonator method. The copper-clad laminate board may be produced by laminating the copper foil and an insulating substrate with adhesive. A publicly known adhesive may be used as the adhesive. The adhesive is preferably an adhesive having low dielectric constant. In the description herein, an adhesive having a dielectric constant of 3.5 or less is referred to as an adhesive having low dielectric constant. In the description herein, a value of dielectric constant (base material dielectric constant, substrate dielectric constant, dielectric constant of resin) means a value of dielectric constant wherein signal frequency is 1GHz, and a value of dielectric dissipation factor (base material dielectric dissipation factor, substrate dielectric dissipation factor, dielectric dissipation factor of resin) means a value of dielectric dissipation factor wherein signal frequency is 1GHz.

The invention relates to, in still another aspect, a copper-clad laminate board including a copper foil and an insulating substrate that are adhered to each other, in which the copper foil has a layer structure, in which the copper foil has a gloss face, a surface roughness Ra (arithmetic average roughness) of a surface of the copper foil on the gloss face side being 0.25 μm or less measured with a laser microscope of and a surface roughness Rz (ten-point average roughness) of the surface of the copper foil on the gloss face side being 1.10 μm or less measured with a laser microscope, in which the copper-clad laminate board has a substrate dielectric constant of 3.5 or less.

The invention relates to, in still another aspect, a copper-clad laminate board including a copper foil and an insulating substrate that are adhered to each other, in which the copper foil has a gloss face, I(220)/I$_0$(220) of 1 or more on a surface of the copper foil on the gloss face side after adhering to the insulating substrate, in which the copper foil has a surface roughness Ra (arithmetic average roughness) of a surface of the copper foil on the gloss face side being 0.25 μm or less measured with a laser microscope and a surface roughness Rz (ten-point average roughness) of the surface of the copper foil on the gloss face side being 1.10 μm or less measured with a laser microscope, and in which the copper-clad laminate board has a substrate dielectric constant of 3.5 or less.

In the case where the copper foil of the copper-clad laminate board has a layer structure, and the copper foil has a surface roughness Ra (arithmetic average roughness) of the surface of the copper foil on the gloss face side being measured with a laser microscope controlled to 0.25 μm or less and a surface roughness Rz (ten-point average roughness) of the surface of the copper foil on the gloss face side being measured with a laser microscope controlled to 1.10 μm or less, the circuit formability on forming a circuit by etching the gloss face side of the copper foil may be improved, and a fine circuit can be formed with high accuracy. Accordingly, the transmission loss can be favorably suppressed in the use thereof in a high frequency circuit.

In the case where the copper-clad laminate board has a substrate dielectric constant of 3.5 or less, such an effect may be obtained that the high frequency characteristics of the substrate (and/or the copper-clad laminate board) are improved, and thereby the transmission loss is further decreased. The substrate dielectric constant of the copper-clad laminate board is preferably 3.0 or less, more preferably 2.5 or less, and further preferably 2.0 or less.

The invention relates to, in still another aspect, a copper foil including a gloss face, after heating at 200°C for 30 minutes or after the heating at 130°C for 30 minutes, and then half-etching with a sulfuric acid-hydrogen peroxide etching solution, a surface roughness Ra (arithmetic average roughness) of a surface of the copper foil on the gloss face side being 0.22 μm or less measured with a laser microscope and a surface roughness Rz (ten-point average roughness) of a surface of the copper foil on the gloss face side being 1.30 μm or less measured with a laser microscope.

The invention relates to, in still another aspect, a copper foil including a gloss face, after heating at 300°C for 30 minutes, and then half-etching with a sulfuric acid-hydrogen peroxide etching solution, a surface roughness Ra (arithmetic average roughness) of a surface of the copper foil on the gloss face side being 0.22 μm or less measured with a laser microscope and a surface roughness Rz (ten-point average roughness) of the surface of the copper foil on the gloss face side being 1.30 μm or less measured with a laser microscope of.

The invention relates to, in still another aspect, a copper foil including a gloss face, after heating at 200°C for 30 minutes or after the heating at 130°C for 30 minutes, and then half-etching with a sulfuric acid-hydrogen peroxide etching solution, a surface roughness Ra (arithmetic average roughness) of a surface of the copper foil on the gloss face side being 0.15 μm or less measured with a laser microscope and a surface roughness Rz (ten-point average roughness) of the surface of the copper foil on the gloss face side being 0.80 μm or less measured with a laser microscope.

The invention relates to, in still another aspect, a copper foil including a gloss face, after heating at 300°C for 30 minutes, and then half-etching with a sulfuric acid-hydrogen peroxide etching solution, a surface roughness Ra (arithmetic average roughness) of a surface of the copper foil on the gloss face side being 0.15 μm or less measured with a laser microscope and a surface roughness Rz (ten-point average roughness) of the surface of the copper foil on the gloss face side being 0.80 μm or less measured with a laser microscope.

The invention relates to, in still another aspect, a copper-clad laminate board including (containing) a copper foil and an insulating substrate that are adhered to each other, in which the copper foil has a gloss face, after half-etching with a sulfuric acid-hydrogen peroxide etching solution, a surface roughness Ra (arithmetic average roughness) of a surface of the copper foil on the gloss face side being 0.22 μm or less measured with a laser microscope and a surface roughness Rz (ten-point average roughness) of the surface of the copper foil on the gloss face side being 1.30 μm or less measured with a laser microscope.

The invention relates to, in still another aspect, a copper-clad laminate board including a copper foil and an insulating substrate that are adhered to each other, in which the copper foil has a gloss face, after half-etching with a sulfuric acid-hydrogen peroxide etching solution, a surface roughness Ra (arithmetic average roughness) of a surface of the copper foil on the gloss face side being 0.15 μm or less measured with a laser microscope and a surface roughness Rz (ten-point average roughness) of the surface of the copper foil on the gloss face side being 0.80 μm or less measured with a laser microscope.

As described above, in the case where the surface of the copper foil on the gloss face side after half-etching with a sulfuric acid-hydrogen peroxide etching solution has a surface roughness Ra (arithmetic average roughness) measured with a laser microscope of 0.22 μm or less and a surface roughness Rz (ten-point average roughness) measured with a laser microscope of 1.30 μm or less, the circuit formability on forming a circuit by etching the gloss face side of the copper foil may be improved, and a fine circuit can be formed with high accuracy. Accordingly, the transmission loss can be favorably suppressed in the use thereof in a high frequency circuit. The surface roughness Ra (arithmetic average roughness) of the surface of the copper foil on the gloss face side measured with a laser microscope is preferably 0.21 μm or less, preferably 0.20 μm or less, preferably 0.15 μm or less, preferably 0.13 μm or less, more preferably 0.12 μm or less, more preferably 0.11 μm or less, and further preferably 0.10 μm or less. The lower limit of the surface roughness Ra (arithmetic average roughness) of the surface of the copper foil on the gloss face side measured with a laser microscope may not be necessarily determined, and may be typically, for example 0.001 μm or more, for example 0.005 μm or more, for example 0.009 μm or more, for example 0.010 μm or more, and for example 0.015 μm or more. The surface roughness Rz (ten-point average roughness) of the surface of the copper foil on the gloss face side measured with a laser microscope is preferably 1.13 μm or less, preferably 1.12 μm or less, preferably 0.74 μm or less, preferably 0.72 μm or less, preferably 0.70 μm or less, more preferably 0.63 μm or less, more preferably 0.60 μm or less, and further preferably 0.50 μm or less. The lower limit of the surface roughness Rz (ten-point average roughness) of the surface of the copper foil on the gloss face side measured with a laser microscope may not be necessarily determined, and may be typically, for example 0.001 μm or more, for example 0.005 μm or more, for example 0.009 μm or more, for example 0.010 μm or more, for example 0.015 μm or more, for example 0.05 μm or more, for example 0.07 μm or more, and for example 0.09 μm or more.

Examples of the sulfuric acid-hydrogen peroxide etching solution and the condition for the half-etching include the following.

Composition of sulfuric acid-hydrogen peroxide etching solution: $H_2O_2$: 21 g/L, $H_2SO_4$: 165 g/L

Half-etching condition: 35°C, 100 rpm, 6 μm dip etching (The etching time varies since the etching speed varies depending on the crystal structure.)

The invention relates to, in still another aspect, a copper foil including a gloss face, after heating at 200°C for 30 minutes or after the heating at 130°C for 30 minutes, and then half-etching with a sodium persulfate etching solution, a surface roughness Ra (arithmetic average roughness) of a surface of the copper foil on the gloss face side being 0.22 μm or less measured with a laser microscope and a surface roughness Rz (ten-point average roughness) of the surface of the copper foil on the gloss face side being 1.30 μm or less measured with a laser microscope.

The invention relates to, in still another aspect, a copper foil including a gloss face, after heating at 300°C for 30 minutes, and then half-etching with a sodium persulfate etching solution, a surface roughness Ra (arithmetic average roughness) of a surface of the copper foil on the gloss face side being 0.22 μm or less measured with a laser microscope and a surface roughness Rz (ten-point average roughness) of a surface of the copper foil on the gloss face side being 1.30 μm or less measured with a laser microscope.

The invention relates to, in still another aspect, a copper-clad laminate board including a copper foil and an insulating substrate that are adhered to each other, in which the copper foil has a gloss face, after half-etching with a sodium persulfate etching solution, a surface roughness Ra (arithmetic average roughness) of a surface of the copper foil on the gloss face side being 0.22 μm or less measured with a laser microscope and a surface roughness Rz (ten-point average roughness) of the surface of the copper foil on the gloss face side being 1.30 μm or less measured with a laser microscope.

As described above, in the case where the surface of the copper foil on the gloss face side after half-etching with a sodium persulfate etching solution has a surface roughness Ra (arithmetic average roughness) being 0.22 μm or less measured with a laser microscope and a surface roughness Rz (ten-point average roughness) being 1.30 μm or less measured with a laser microscope, the circuit formability on forming a circuit by etching the gloss surface of the copper foil may be improved, and a fine circuit can be formed with high accuracy. Accordingly, the transmission loss can be favorably suppressed in the use thereof in a high frequency circuit. The surface roughness Ra (arithmetic average roughness) of the surface of the copper foil on the gloss face side measured with a laser microscope is preferably 0.21 μm or less, preferably 0.20 μm or less, more preferably 0.18 μm or less, further preferably 0.16 μm or less, still further preferably 0.15 μm or less, and still further preferably 0.11 μm or less. The lower limit of the surface roughness Ra (arithmetic average roughness) of the surface of the copper foil on the gloss face side measured with a laser microscope may not be necessarily determined, and may be typically, for example 0.001 μm or more, for example 0.005 μm or more, for example 0.009 μm or more, for example 0.010 μm or more, and for example 0.015 μm or more. The surface roughness Rz (ten-point average roughness) of the surface of the copper foil on the gloss face side measured with a laser microscope is preferably 1.20 μm or less, preferably 1.13 μm or less, preferably 1.12 μm or less, preferably 1.00 μm or less, still further preferably 0.80 μm or less, preferably 0.74 μm or less, preferably 0.72 μm or less, preferably 0.63 μm or less, and preferably 0.60 μm. The lower limit of the surface roughness Rz (ten-point average roughness) of the surface of the copper foil on the gloss face side measured with a laser microscope may not be necessarily determined, and is typically, for example 0.001 μm or more, for example 0.005 μm or more, for example 0.009 μm or more, for example 0.010 μm or more, for example 0.015 μm or more, for example 0.05 μm or more, for example 0.07 μm or more, and for example 0.09 μm or more.

Examples of the sodium persulfate etching solution and the condition for the half-etching include the following.

Composition of sodium persulfate etching solution: $Na_2S_2O_8$: 50 g/L, $H_2SO_4$: 35 g/L
Half-etching condition: 35°C, 100 rpm, 6 μm dip etching (The etching time varies since the etching speed varies depending on the crystal structure.)

A printed wiring board can be produced by using the copper-clad laminate board. The method for producing a printed wiring board from the copper-clad laminate board is not particularly limited, and it suffices to use a known etching process. A printed circuit board can be produced by mounting various electronic components on the printed wiring board. In the description herein, the printed circuit board is included in the printed wiring board. The printed wiring board can be mounted on various electronic apparatuses.

The copper-clad laminate board according to the aspect of the invention can be used particularly favorably in a transmission channel, an antenna, and the like that are used under a high frequency exceeding 1 GHz.

The copper foil according to the aspect of the invention can also be favorably used as a cell material, such as a negative electrode collector of a secondary cell, such as a lithium ion secondary cell. This is because the copper foil according to the aspect of the invention can reduce the fluctuation of the amount of the active substance attached to the surface of the copper foil due to the excellent etching processability thereof and/or the controlled Ra and Rz of the surface of the copper foil.

EXAMPLES

The invention will be described with reference to examples shown below. The examples show only preferred examples and do not limit the invention in any way. Accordingly, all modifications, examples, and embodiments within the technical concept of the invention are included in the invention. Comparative examples will also be shown below for the comparison to the invention. The balances of the liquids used in the roughening treatment, the plating, the silane coupling treatment, the heat resistance treatment, the rust prevention treatment, and the like described in the experimental examples described herein each are water unless otherwise indicated.

For copper foils of Examples 1, 2, 4, 6, and 8 to 16, an ingot containing an oxygen-free copper having Sn added thereto in an amount of 1,200 ppm was manufactured. The ingot was hot-rolled from 900°C, and then repeatedly subjected to cold rolling and annealing, and the resulting copper foil was finally cold-rolled (which may be referred to as "final cold rolling") to provide a rolled copper foil having a thickness of 9 $\mu$m. The reduction in the final cold rolling, the average crystal grain size on the cross section in parallel to the rolling direction of the copper foil and in parallel to the thickness direction thereof before the final cold rolling, the oil film equivalent amount in the final cold rolling, and the arithmetic average roughness Ra of the rolling mill roll used in the final cold rolling are shown in Tables 1 and 2. The arithmetic average roughness Ra of the rolling mill roll used in the final cold rolling in Examples 1, 2, 4, 6, 8, 9, and 11 to 16 was 0.1 $\mu$m. The arithmetic average roughness Ra of the surface of the rolling mill roll used in the final cold rolling in Example 10 was 0.09 $\mu$m.

For copper foils of Example 5 and Comparative Example 5, an ingot containing an oxygen-free copper having Sn added thereto in an amount of 2,300 ppm was manufactured. The ingot was hot-rolled from 900°C, and then repeatedly subjected to cold rolling and annealing, and the resulting copper foil was finally subjected to final cold rolling to provide a rolled copper foil having a thickness of 9 $\mu$m. The reduction in the final cold rolling, the average crystal grain size on the cross section in parallel to the rolling direction of the copper foil and in parallel to the thickness direction thereof before the final cold rolling, the oil film equivalent amount in the final cold rolling, and the arithmetic average roughness Ra of the surface of the rolling mill roll used in the final cold rolling are shown in Tables 1 and 2. The arithmetic average roughness Ra of the rolling mill roll used in the final cold rolling was 0.1 $\mu$m.

For copper foils of Examples 3 and 20 and Comparative Examples 2 and 6, an ingot of a tough pitch copper (JIS H3100, alloy number: C1100) was manufactured. The ingot was hot-rolled from 900°C, and then repeatedly subjected to cold rolling and annealing, and the resulting copper foil was finally subjected to final cold rolling to provide a rolled copper foil having a thickness of 18 $\mu$m. The reduction in the final cold rolling, the average crystal grain size on the cross section in parallel to the rolling direction of the copper foil and in parallel to the thickness direction thereof before the final cold rolling, the oil film equivalent amount in the final cold rolling, and the arithmetic average roughness Ra of the surface of the rolling mill roll used in the final cold rolling are shown in Tables 1 and 2. The arithmetic average roughness Ra of the rolling mill roll used in the final cold rolling was 0.1 $\mu$m.

For copper foils of Example 7 and Comparative Examples 1, 3, and 8, an ingot containing a tough pitch copper having Ag added thereto in an amount of 190 ppm was manufactured. The ingot was hot-rolled from 900°C, and then repeatedly subjected to cold rolling and annealing, and the resulting copper foil was finally subjected to final cold rolling to provide a rolled copper foil having a thickness of 12 $\mu$m. The reduction in the final cold rolling, the average crystal grain size on the cross section in parallel to the rolling direction of the copper foil and in parallel to the thickness direction thereof before the final cold rolling, the oil film equivalent amount in the final cold rolling, and the arithmetic average roughness Ra of the surface of the rolling mill roll used in the final cold rolling are shown in Tables 1 and 2. The arithmetic average roughness Ra of the rolling mill roll used in the final cold rolling was 0.1 $\mu$m.

For copper foils for Comparative Examples 4 and 7, an electrolytic copper foil having a thickness of 12 $\mu$m was produced under the following condition.

Composition of electrolytic solution: Cu (as $Cu^{2+}$) : 100 g/L, $H_2SO_4$: 100 g/L, Cl⁻: 100 mg/L, thiourea: 2.5 mg/L
Temperature of electrolytic solution: 58°C (Comparative Example 4), 62°C (Comparative Example 7)
Current density: 65 A/dm$^2$ (Comparative Example 4), 45 A/dm$^2$ (Comparative Example 7)

For copper foils of Examples 17 to 19 and 21 to 30 and Comparative Examples 9 to 13, ingots having the compositions shown in the column "Copper foil component" in Tables 1 and 2 were manufactured. The ingots each were hot-rolled from 900°C, and then repeatedly subjected to cold rolling and annealing, and the resulting copper foil was finally subjected to final cold rolling to provide a rolled copper foil having the thickness shown in Tables 1 and 2. The reduction in the final cold rolling, the average crystal grain size on the cross section in parallel to the rolling direction of the copper foil and in parallel to the thickness direction thereof before the final cold rolling, the oil film equivalent amount in the final cold rolling, and the arithmetic average roughness Ra of the surface of the rolling mill roll used in the final cold rolling are shown in Tables 1 and 2.

In a column of "Component of copper foil" in Tables 1 and 2, "TPC" means tough pitch copper, and "OFC" means oxygen-free copper. That is, for example, "1200ppm Zr-OFC" of Example 22 means that the component of copper foil is the oxygen-free copper added Zr of 1200 ppm by mass. Further, for example, "190ppm Ag-TPC" of Example 7 means that the component of copper foil is the tough pitch copper added Ag of 190 ppm by mass.

In a column of "Insulating substrate" in Tables 1 and 2, "liquid crystal polymer", "polyimide having adhesive", "COP (laminated with adhesive)", "fluorine resin" mean the followings insulating substrates.

> liquid crystal polymer: Liquid crystal polymer resin which is a copolymer of hydroxybenzoic acid (ester) and hydroxynaphthoic acid (ester), vecstor CT-Z by KURARAY CO.,LTD.
> polyimide having adhesive: Low induction polyimide resin, polyimide resin having a dielectric dissipation factor of 0.002. The adhesive is low dielectric constant adhesive.
> COP (laminated with adhesive): Cycloolefin polymer resin is laminated to the copper foil with adhesive. The adhesive is low dielectric constant adhesive.
> fluorine resin: PTFE, polytetrafluoroethylene resin.

The copper foils of Examples 1, 3, and 7 and Comparative Examples 1, 2, and 4 each were subjected to surface treatments including a roughening treatment, a heat resistant layer forming treatment, a rust prevention treatment, and a silane coupling treatment in this order on the surface of the copper foil to be adhered to a resin. The conditions of the treatments were as follows.

Roughening Treatment

> Composition of electrolytic solution: Cu: 10 to 30 g/L
> (added as copper sulfate pentahydrate), sulfuric acid: 80 to 120 g/L
> Temperature of solution: 20 to 40°C
> Current density: 120 to 140 A/dm$^2$

Heat Resistant Layer (Zinc-Nickel Plating) forming Treatment

> Composition of solution: nickel concentration: 10 to 30 g/L, zinc concentration: 1 to 15 g/L
> Temperature of solution: 30 to 50°C
> Current density: 1 to 10 A/dm$^2$

Rust Prevention Treatment (Chromate Treatment)

> Composition of solution: potassium bichromate concentration: 3 to 5 g/L, zinc concentration: 0.1 to 1 g/L
> Temperature of solution: 30 to 50°C
> Current density: 0.1 to 3.0 A/dm$^2$

Silane Coupling Treatment

The treatment was performed by coating a silane coupling agent by spraying a solution of pH 7 to 8 containing from 0.2 to 2% by weight of an alkoxysilane.

The copper foils of Examples 1, 4, 13, 22 to 25, 29, and 30 and Comparative Examples 3 and 7 each were laminated with a liquid crystal polymer having a thickness of 50 μm and a dielectric constant shown in Tables 1 and 2, so as to produce a copper-clad laminate board.

The copper foils of Examples 2, 21, and 26 and Comparative Example 2 each were laminated with a polyimide having a thickness of 50 μm and a dielectric constant shown in Tables 1 and 2 having an adhesive, so as to produce a copper-clad laminate board.

The copper foils of Examples 3, 7, 8, and 20 and Comparative Example 8 each were laminated with a cycloolefin polymer (COP) having a thickness of 50 μm by hot press through a low dielectric constant adhesive capable of performing adhesion at a low temperature, so as to produce a copper-clad laminate board.

The copper foils of Examples 5, 6, 9 to 12, 14 to 19, 27, and 28 and Comparative Examples 4, 5, 6, and 9 to 13 each were laminated with a fluorine resin having a thickness of 50 μm and a dielectric constant shown in Tables 1 and 2, so as to produce a copper-clad laminate board.

The copper foil of Comparative Example 1 was laminated with an epoxy resin having a thickness of 50 μm and a dielectric constant shown in Tables 1 and 2, so as to produce a copper-clad laminate board. The lamination temperatures and the lamination times for laminating the copper foils with the resins, e.g., the epoxy resin, the fluorine resin, the liquid crystal polymer, the polyimide, and the cycloolefin polymer, for producing the copper-clad laminate boards are shown in the column "Heat-treatment Condition" in Tables 1 and 2.

Average Thickness of Crystal Grains of Copper Foil

The copper foils before forming into the copper-clad laminate board (before forming board) and after forming into the copper-clad laminate board (after forming board) each were processed into a thin piece with a focused ion beam (FIB) equipment, so as to provide a cross sectional piece in parallel to the rolling direction and in parallel to the thickness direction for the rolled copper foil, and to provide a cross sectional piece in parallel to the traveling direction of the copper foil in the production of the electrolytic copper foil and in parallel to the thickness direction for the electrolytic copper foil, and the cross sectional piece was observed with a scanning ion microscope (SIM) to provide a micrograph with a magnitude of 10,000. The grain length (the grain size) of the crystal grains in the thickness direction in the micrograph was measured by the section method according to JIS H0501 with the number of specimen of 5, and the arithmetic average value of the grain length of the crystal grains in the thickness direction was designated as the average thickness of the crystal grains of the copper foil.

I(220)/I$_0$(220)

The copper foil after forming into the copper-clad laminate board (after forming board) was measured by X-ray diffraction for I(220)/I$_0$(220) on the surface of the copper foil on the gloss face side after the heat treatment shown in Tables 1 and 2. The value I(220) is the integrated value of the intensity of the (220) plane in the measurement of the surface of the copper foil by X-ray diffraction. The value Io(220) is the integrated value of the intensity of the (220) plane in the measurement of fine powder copper (325 mesh) by X-ray diffraction.

Structure of Copper Foil

The copper foils before forming into the copper-clad laminate board (before forming board) and after forming into the copper-clad laminate board (after forming board) each were processed into a thin piece with a focused ion beam (FIB) equipment, so as to provide a cross sectional piece in parallel to the rolling direction and in parallel to the thickness direction for the rolled copper foil, and to provide a cross sectional piece in parallel to the traveling direction of the copper foil in the production of the electrolytic copper foil and in parallel to the thickness direction for the electrolytic copper foil, and the cross sectional piece was observed with a scanning ion microscope (SIM) to provide a micrograph with a magnitude of 10,000. The micrograph was visually observed for determining the layer structure, the recrystallized structure, and the columnar crystal structure. The rolling direction is a direction parallel to the traveling direction of the copper foil in the production with a rolling mill.

Layer Structure

In the observation of the cross section of the copper foil in parallel to the rolling direction for the rolled copper foil, or in the observation of the cross section of the copper foil in parallel to the traveling direction of the copper foil in the production of the electrolytic copper foil or in the production of the other copper foils for the electrolytic copper foil or the other copper foils, a structure containing long and thin crystal grains (having a ratio of the long diameter and the short diameter (long diameter/short diameter), for example, of more than 2) extending in the rolling direction or the traveling direction of the electrolytic copper foil that are accumulated is designated as the layer structure. Fig. 1 is a cross sectional observation micrograph of the layer structure. In the case where the cross section contained the layer structure even slightly, the copper foil was determined to have the layer structure. The long diameter herein is the diameter of the minimum circle surrounding the crystal grain. The short diameter herein is the diameter of the maximum circle contained in the crystal grain.

Recrystallized Structure

In the observation of the cross section of the copper foil in parallel to the rolling direction for the rolled copper foil, or in the observation of the cross section of the copper foil in parallel to the traveling direction of the copper foil in the production of the electrolytic copper foil for the electrolytic copper foil, a crystal structure containing, as the most part (for example, 95% or more in terms of area ratio on the cross section observed), crystal grains in the form of particles (having a ratio of the long diameter and the short diameter (long diameter/short diameter), for example, of from 1 to 2) is designated as the recrystallized structure. The long diameter herein is the diameter of the minimum circle surrounding the crystal grain. The short diameter herein is the diameter of the maximum circle contained in the crystal grain.

Columnar Crystal Structure

In the observation of the cross section of the copper foil in parallel to the rolling direction for the rolled copper foil, or in the observation of the cross section of the copper foil in parallel to the traveling direction of the copper foil in the production of the electrolytic copper foil for the electrolytic copper foil, a structure containing crystal grains extending in the thickness direction is designated as the columnar crystal structure.

The copper foils before forming into the copper-clad laminate board each had the layer structure for the rolled copper foil or the columnar crystal structure for the electrolytic copper foil.

The copper foils having been formed into the copper-clad laminate board were determined for the crystal structure by the aforementioned method. The results are shown in the column "Crystal structure of copper foil after forming board" in Tables 1 and 2. The lamination temperatures and the lamination times for laminating the copper foils with the resin for producing the copper-clad laminate boards were the temperatures and the times shown in the column "Heat-treatment Condition" in Tables 1 and 2.

In the determination of the structure of the copper foil described above, the area ratio of the layer structure was also measured. The micrograph obtained with a scanning ion microscope (SIM) described above was printed, and a transparent film was placed on the printed image. The region of the transparent film corresponding to the layer structure was filled with or drawn for the outline thereof with a black ink or the like. Thereafter, the transparent film was photographed to convert to electronic data, and the area of the region filled with or drawn for the outline thereof with a black ink or the like and the area of the copper foil within the observation field were calculated by using a commercially available image analyzing software (LUZEX-F, available from Nireco Corporation, or Photoshop 7.0, available from Adobe Systems, Inc.). The area ratio (%) of the layer structure was calculated by dividing the total area of the regions of the layer structure by the area of the copper foil in the observation field, as shown in the following expression. The aforementioned image analyzing programs are ordinary ones, and there is no particular limitation therefor in the invention.

$$\text{(area ratio of layer structure (\%))} = \text{((total area of layer structure in observation field } (\mu m^2)) \text{ / (area of copper foil in observation field } (\mu m^2))) \times 100$$

The measurement was performed for three fields, and the average value of the area ratios of the layer structure of the three fields was designated as the area ratio of the layer structure.

Average Crystal Grain Size of Copper Foil before Final Cold Rolling

In the case where the copper foil of Example or Comparative Example was a rolled copper foil, the average crystal grain size on the cross section in parallel to the rolling direction of the copper foil before the final cold rolling and in parallel to the thickness direction thereof was measured by the section method (JIS H0501). The measurement was performed for three fields, and the average value of the average crystal grain sizes of the three fields was designated as the average crystal grain size of the copper foil before the final cold rolling.

Surface Roughness

The copper foils of Examples and Comparative Examples each were measured for Ra (arithmetic average roughness) of the surface of the copper foil on a gloss face side (which was the surface subjected to the surface treatment for Examples and Comparative Examples performing the surface treatment) according to JIS B0601-1994 with a laser microscope, OLS 4000 (LEXT OLS 4000), available from Olympus Corporation. The value of Ra (arithmetic average roughness) in TD (i.e., the transverse direction, the width direction, the direction perpendicular to the traveling direction of the copper foil in the copper foil production equipment, or the direction perpendicular to the rolling direction) of the copper foil was measured for 10 arbitrary positions, and the average value of the Ra (arithmetic average roughness) of the 10 positions was designated as the value of Ra (arithmetic average roughness) of the surface of the copper foil on the gloss face side. The copper foils each were measured for Rz (ten-point average roughness) of the surface of the copper foil on the gloss face side according to JIS B0601-1994 with a laser microscope, LEXT OLS 4000, available from Olympus Corporation. The value of Rz (ten-point average roughness) in TD (i.e., the transverse direction, the width direction, the direction perpendicular to the traveling direction of the copper foil in the copper foil production equipment, or the direction perpendicular to the rolling direction) of the copper foil was measured for 10 arbitrary positions, and the average value of the Rz (ten-point average roughness) of the 10 positions was designated as the value of Rz (ten-point average roughness) of the surface of the copper foil on the gloss face side.

For each of the copper foils of Examples and Comparative Examples, after a thickness of 6 $\mu$m from the gloss face side thereof was removed by etching (half-etching), and the values of Ra (arithmetic average roughness) and Rz (ten-point average roughness) were evaluated on the surface of the copper foil on the gloss face side in the same manner as above. The half-etching conditions are shown in Table 3. In the case where the same measurements as above were performed except that the etching was performed to the half of the thickness of the copper foil before etching, the same values of Ra and Rz were obtained. The half-etching was performed under the etching condition with the etching solution having the composition shown in the column "Etching condition" in Table 3. The thickness of the copper foil removed by etching was calculated by the following expression. The specimen of the copper foil had a size of 5 cm x 5 cm square.

$$\text{(Thickness of copper foil removed by etching } (\mu m) = ((\text{weight of specimen of copper foil before etching } (g)) - (\text{weight of specimen of copper foil after etching } (g))) / ((\text{area of specimen of copper foil, } 25 \ (cm^2)) \times (\text{density of copper, } 8.94 \ (g/cm^3))) \times 10^4 \ (\mu m/cm)$$

For Comparative examples 9, 11, and 12, the values of Ra (arithmetic average roughness) of the surface of the copper foil on the gloss face side in MD and Rz (ten-point average roughness) of the surface of the copper foil on the gloss face side in MD (i.e., the machine direction, the longitudinal direction, the traveling direction of the copper foil in the copper foil production equipment, or the direction in parallel to the rolling direction) of the copper foil were measured in the same manner as above on the surface of the copper foil on the gloss face side after the half-etching. As a result, the value of Ra was 0.18 $\mu$m and the value of Rz was 1.01 $\mu$m for MD of Comparative Example 9, the value of Ra was 0.27 $\mu$m and the value of Rz was 0.67 $\mu$m for MD of Comparative Example 11, and the value of Ra was 0.10 $\mu$m and the value of Rz was 0.91 $\mu$m for MD of Comparative Example 12. For Comparative Example 9, the values of Ra (arithmetic average roughness) and Rz (ten-point average roughness) in MD were measured in the same manner as above on the surface of the copper foil after the half-etching. As a result, the value of Ra was 0.10 $\mu$m for MD of Comparative Example 9.

Measurement of Substrate Dielectric Constant

After producing the copper-clad laminate board, the substrate dielectric constant wherein signal frequency is 1GHz was measured according to JPCA-TM001-2007 "Test method for copper-clad laminates for printed wiring boards dielectric constant and dissipation factor" by Japan Electronics Packaging and Circuits Association, by the triplate resonator method.

Circuit Formability

In each of the copper-clad laminate boards after the half-etching, a circuit was formed by etching to have a micro-strip line structure providing a characteristic impedance of 50 $\Omega$.

The circuit formability at this time was evaluated in the following manner.

In the production of a micro-strip line of 100 mm, the circuit width was observed, and the circuit formability was evaluated as "S" with a deviation of the characteristic impedance of $\pm 3 \ \Omega$ or less, "AA" with a deviation of the characteristic impedance of more than $\pm 3 \ \Omega$ and $\pm 4 \ \Omega$ or less, "A" with a deviation of the characteristic impedance of more than $\pm 4$ $\Omega$ and $\pm 5 \ \Omega$ or less, "B" with a deviation of the characteristic impedance of more than $\pm 5 \ \Omega$ and $\pm 8 \ \Omega$ or less, and "C" with a deviation of the characteristic impedance of more than $\pm 8 \ \Omega$.

High-Frequency Characteristics

The transmission characteristics were measured for the circuit, and evaluated as "S" with a transmission loss at a frequency of 20 GHz of less than -4.5 dB/cm, "AA" with a transmission loss at a frequency of 20 GHz of -4.5 dB/cm or more and less than -4.7 dB/cm, "A" with a transmission loss at a frequency of 20 GHz of -4.7 dB/cm or more and less than -5 dB/10 cm, "B" with a transmission loss at a frequency of 20 GHz of -5 dB/10 cm or more and less than -6 dB/10 cm, and "C" with a transmission loss at a frequency of 20 GHz of -6 dB/10 cm or more.
The test results are shown in Tables 1 to 3.

Table 1

| | Kind of copper foil | Average crystal grain size before final cold rolling (μm) | Component of copper foil (ppm by mass) | Rolling reduction in final cold rolling | Oil film equivalent amount in final cold rolling | Surface roughness Ra of rolling mill roll used in final cold rolling (μm) | Thickness of copper foil after final cold rolling (μm) | Insulating substrate | Dielectric constant of substrate (substrate dielectric constant) | Heat treatment condition | Before forming board: Average thickness of crystal grains | Crystal structure of copper foil after forming board | Area ratio of layer structure after forming board (%) |
|---|---|---|---|---|---|---|---|---|---|---|---|---|---|
| Example 1 | rolled copper foil | 4.5 | 1200 ppm Sn-OFC | 95.3 | 18000 | 0.10 | 9 | liquid crystal polymer | 2.9 | 300°C 30 min | 0.2 μm | layer structure | 100 |
| Example 2 | rolled copper foil | 4.5 | 1200 ppm Sn-OFC | 95.3 | 18000 | 0.10 | 9 | polyimide having adhesive | 3.2 | 200°C 30 min | 0.2 μm | layer structure | 100 |
| Example 3 | rolled copper foil | 11.6 | TPC | 97.1 | 19000 | 0.10 | 18 | COP (laminated with adhesive) | 2.4 | 130°C 30 min | 0.3 μm | layer structure | 100 |
| Example 4 | rolled copper foil | 3.6 | 1200 ppm Sn-OFC | 97.2 | 17000 | 0.10 | 9 | liquid crystal polymer | 2.9 | 300°C 30 min | 0.1 μm | layer structure | 100 |
| Example 5 | rolled copper foil | 3.3 | 2300 ppm Sn-OFC | 90.2 | 18500 | 0.10 | 9 | fluorine resin | 2.1 | 300°C 30 min | 0.3 μm | layer structure | 100 |
| Example 6 | rolled copper foil | 6.3 | 1200 ppm Sn-OFC | 95.3 | 25000 | 0.10 | 9 | fluorine resin | 2.1 | 300°C 30 min | 0.2 μm | layer structure | 100 |
| Example 7 | rolled copper foil | 7.4 | 190 ppm Ag-TPC | 98.1 | 24000 | 0.10 | 12 | COP (laminated with adhesive) | 2.4 | 130°C 30 min | 0.1 μm | layer structure | 100 |
| Example 8 | rolled copper foil | 4.5 | 1200 ppm Sn-OFC | 95.3 | 18000 | 0.10 | 9 | COP (laminated with adhesive) | 2.4 | 130°C 30 min | 0.2 μm | layer structure | 100 |
| Example 9 | rolled copper foil | 17.6 | 1200 ppm Sn-OFC | 97.2 | 42000 | 0.10 | 9 | fluorine resin | 2.1 | 300°C 30 min | 0.2 μm | layer structure | 100 |
| Example 10 | rolled copper foil | 17.6 | 1200 ppm Sn-OFC | 97.2 | 42000 | 0.09 | 9 | fluorine resin | 2.1 | 300°C 30 min | 0.2 μm | layer structure | 100 |
| Example 11 | rolled copper foil | 3.4 | 1200 ppm Sn-OFC | 90.2 | 19000 | 0.10 | 9 | fluorine resin | 2.1 | 300°C 30 min | 0.3 μm | layer structure | 100 |
| Example 12 | rolled copper foil | 3.5 | 1200 ppm Sn-OFC | 90.2 | 19500 | 0.10 | 9 | fluorine resin | 2.1 | 300°C 30 min | 0.3 μm | layer structure | 100 |
| Example 13 | rolled copper foil | 2.4 | 1200 ppm Sn-OFC | 90.2 | 20000 | 0.10 | 9 | liquid crystal polymer | 2.1 | 300°C 30 min | 0.2 μm | layer structure | 100 |
| Example 14 | rolled copper foil | 2.5 | 1200 ppm Sn-OFC | 90.2 | 20500 | 0.10 | 9 | fluorine resin | 2.1 | 300°C 30 min | 0.2 μm | layer structure | 100 |
| Example 15 | rolled copper foil | 3.9 | 1200 ppm Sn-OFC | 80.2 | 16500 | 0.10 | 9 | fluorine resin | 2.1 | 300°C 30 min | 0.8 μm | layer structure | 100 |
| Example 16 | rolled copper foil | 2.9 | 1200 ppm Sn-OFC | 80.2 | 16500 | 0.10 | 9 | fluorine resin | 2.1 | 300°C 30 min | 0.6 μm | layer structure | 100 |
| Example 17 | rolled copper foil | 11.2 | 600 ppm Sn-OFC | 99.0 | 19000 | 0.10 | 9 | fluorine resin | 2.1 | 300°C 30 min | 0.1 μm | layer structure | 71 |
| Example 18 | rolled copper foil | 11.2 | 400 ppm Sn-OFC | 99.0 | 19000 | 0.10 | 9 | fluorine resin | 2.1 | 300°C 30 min | 0.1 μm | layer structure | 52 |
| Example 19 | rolled copper foil | 11.2 | 300 ppm Sn-OFC | 99.0 | 19000 | 0.10 | 9 | fluorine resin | 2.1 | 300°C 30 min | 0.1 μm | layer structure | 34 |
| Example 20 | rolled copper foil | 12.1 | TPC | 99.1 | 18500 | 0.10 | 18 | COP (laminated with adhesive) | 2.4 | 130°C 30 min | 0.1 μm | recrystallized structure | 0 |
| Example 21 | rolled copper foil | 3.6 | 100 ppm Sn-100 ppm Mg-100 ppm Ti-100 ppm In-100 ppm Fe-100 ppm Cr-OFC | 97.2 | 17000 | 0.10 | 9 | polyimide having adhesive | 3.2 | 200°C 30 min | 0.1 μm | layer structure | 100 |
| Example 22 | rolled copper foil | 3.6 | 1200 ppm Zr-OFC | 97.2 | 17000 | 0.10 | 9 | liquid crystal polymer | 2.9 | 300°C 30 min | 0.1 μm | layer structure | 100 |
| Example 23 | rolled copper foil | 3.6 | 2000 ppm Cr-1000 ppm Zr-OFC | 97.2 | 17000 | 0.10 | 9 | liquid crystal polymer | 2.9 | 300°C 30 min | 0.1 μm | layer structure | 100 |
| Example 24 | rolled copper foil | 3.6 | 100 ppm Ni-100 ppm P-100 ppm Zn-100 ppm Si-OFC | 97.2 | 17000 | 0.10 | 9 | liquid crystal polymer | 2.9 | 300°C 30 min | 0.1 μm | layer structure | 100 |
| Example 25 | rolled copper foil | 3.6 | 200 ppm Co 200 ppm Mo 200 ppm Mn-100 ppm Al-OFC | 97.2 | 17000 | 0.10 | 9 | liquid crystal polymer | 2.9 | 300°C 30 min | 0.1 μm | layer structure | 100 |
| Example 26 | rolled copper foil | 3.6 | 200 ppm P-OFC | 97.2 | 17000 | 0.10 | 9 | polyimide having adhesive | 3.2 | 200°C 30 min | 0.1 μm | layer structure | 100 |
| Example 27 | rolled copper foil | 7.8 | 1200 ppm Sn-OFC | 97.2 | 37000 | 0.11 | 9 | fluorine resin | 2.1 | 300°C 30 min | 0.1 μm | layer structure | 100 |
| Example 28 | rolled copper foil | 7.3 | 1200 ppm Sn-OFC | 85.0 | 37000 | 0.07 | 9 | fluorine resin | 2.1 | 300°C 30 min | 0.5 μm | layer structure | 100 |

Table 2

| | Kind of copper foil | Average crystal grain size before final cold rolling (μm) | Component of copper foil (ppm by mass) | Rolling reduction in final cold rolling | Oil film equivalent amount in final cold rolling | Surface roughness Ra of rolling mill roll used in final cold rolling (μm) | Thickness of copper foil after final cold rolling (μm) | Insulating substrate | Dielectric constant of substrate (substrate dielectric constant) | Heat treatment condition | Before forming board — Average thickness of crystal grains | Crystal structure of copper foil after forming board | Area ratio of layer structure after forming board (%) |
|---|---|---|---|---|---|---|---|---|---|---|---|---|---|
| Example 29 | rolled copper foil | 2.9 | 100 ppm Sn–50 ppm Au–50 ppm Pd–100 ppm B–100 ppm S–100 ppm V–100 ppm W–100 ppm As–100 ppm Be–OFC | 97.2 | 14000 | 0.04 | 9 | liquid crystal polymer | 2.9 | 300℃ 30 min | 0.1 μm | layer structure | 100 |
| Example 30 | rolled copper foil | 3.2 | 100 ppm Ta–50 ppm Ca–100 ppm Cl–100 ppm Ga–100 ppm Ge–100 ppm Sb–100 ppm Bi–OFC | 97.2 | 15000 | 0.04 | 9 | liquid crystal polymer | 2.9 | 300℃ 30 min | 0.1 μm | layer structure | 100 |
| Comparative Example1 | rolled copper foil | 14.9 | 190 ppm Ag–TPC | 98.1 | 24000 | 0.10 | 12 | epoxy resin | 4.7 | 200℃ 30 min | 0.2 μm | recrystallized structure | 0 |
| Comparative Example2 | rolled copper foil | 20.6 | TPC | 98.5 | 17500 | 0.10 | 18 | polyimide having adhesive | 3.2 | 200℃ 30 min | 0.3 μm | recrystallized structure | 0 |
| Comparative Example3 | rolled copper foil | 24.0 | 190 ppm Ag–TPC | 99.4 | 24500 | 0.10 | 12 | liquid crystal polymer | 2.9 | 300℃ 30 min | 0.1 μm | recrystallized structure | 0 |
| Comparative Example4 | electrolytic copper foil | – | ED | – | – | – | 12 | fluorine resin | 2.1 | 300℃ 30 min | >1 μm | columnar crystal structure | 0 |
| Comparative Example5 | rolled copper foil | 20.6 | 2300 ppm Sn–OFC | 99.5 | 17500 | 0.10 | 9 | fluorine resin | 2.1 | 300℃ 30 min | 0.1 μm | recrystallized structure | 0 |
| Comparative Example6 | rolled copper foil | 22.4 | TPC | 98.5 | 19000 | 0.10 | 18 | fluorine resin | 2.1 | 300℃ 30 min | 0.3 μm | recrystallized structure | 0 |
| Comparative Example7 | electrolytic copper foil | – | ED | – | – | – | 12 | liquid crystal polymer | 2.9 | 300℃ 30 min | >1 μm | columnar crystal structure | 0 |
| Comparative Example8 | rolled copper foil | 22.5 | 190 ppm Ag–TPC | 99.4 | 23000 | 0.10 | 12 | COP (laminated with adhesive) | 2.4 | 130℃ 30 min | 0.1 μm | recrystallized structure | 0 |
| Comparative Example9 | rolled copper foil | 1.8 | 1200 ppm Sn–1000 ppm Mg–500 ppm Ag–electrolytic copper (Cu concentration: 99.96% by mass or more) | 88.0 | 52000 | 0.04 | 12 | fluorine resin | 2.1 | 300℃ 30 min | 0.03 μm | layer structure | 25 |
| Comparative Example10 | rolled copper foil | 5.1 | 1140 ppmSn–OFC | 94.0 | 10000 | 0.25 | 9 | fluorine resin | 2.1 | 300℃ 30 min | 0.5 μm | layer structure | 100 |
| Comparative Example11 | rolled copper foil | 21.0 | 1220 ppmSn–OFC | 90.0 | 25000 | 0.25 | 7 | fluorine resin | 2.1 | 300℃ 30 min | 1.9 μm | layer structure | 100 |
| Comparative Example12 | rolled copper foil | 8.0 | 500 ppmCr–500 ppmAg–electrolytic copper (Cu concentration: 99.96% by mass or more) | 96.0 | 45000 | 0.05 | 18 | fluorine resin | 2.1 | 300℃ 30 min | 0.2 μm | layer structure | 100 |
| Comparative Example13 | rolled copper foil | 1.0 | 1200 ppmSn–1000 ppmMg–500 ppmAg–electrolytic copper (Cu concentration: 99.96% by mass or more) | 88.0 | 52000 | 0.04 | 12 | fluorine resin | 2.1 | 300℃ 30 min | 0.01 μm | recrystallized structure | 0 |

Table 3

| | Copper foil after forming board | | Etching condition (dipping method, agitation: 100 rpm, 6 μm etching) | Surface roughness of surface of copper foil on gloss face side before etching (a) | | Surface roughness of surface of copper foil on gloss face side after 6 μm etching (b) | | Circuit formability | High frequency characteristics |
|---|---|---|---|---|---|---|---|---|---|
| | Average thickness of crystal grains | I(220)/I0 (220) | | Ra (μm) | Rz (μm) | Ra (μm) | Rz (μm) | | |
| Example 1 | 0.2 μm | 7.5 | H2O2 21g/L, H2SO4 165g/L. 35°C | 0.08 | 0.48 | 0.09 | 0.50 | S | S |
| Example 2 | 0.2 μm | 7.5 | H2O2 21g/L, H2SO4 165g/L, 35°C | 0.08 | 0.48 | 0.08 | 0.49 | S | S |
| Example 3 | 0.3 μm | 5.9 | H2O2 21g/L, H2SO4 165g/L, 35°C | 0.09 | 0.55 | 0.09 | 0.53 | S | S |
| Example 4 | 0.2 μm | 8.1 | H2O2 21g/L, H2SO4 165g/L, 35°C | 0.07 | 0.43 | 0.11 | 0.53 | S | S |
| Example 5 | 0.3 μm | 7.1 | H2O2 21g/L, H2SO4 165g/L, 35°C | 0.09 | 0.51 | 0.10 | 0.60 | S | S |
| Example 6 | 0.2 μm | 7.5 | Na2S2O8 50g/L, H2SO4 35g/L, 35°C | 0.12 | 0.72 | 0.19 | 1.13 | A | A |
| Example 7 | 0.1 μm | 6.2 | Na2S2O8 50g/L, H2SO4 35g/L, 35°C | 0.11 | 0.68 | 0.18 | 1.07 | A | A |
| Example 8 | 0.2 μm | 7.5 | H2O2 21g/L, H2SO4 165g/L, 35°C | 0.08 | 0.48 | 0.08 | 0.49 | S | S |
| Example 9 | 0.2 μm | 8.1 | H2O2 21g/L, H2SO4 165g/L, 35°C | 0.26 | 1.21 | 0.22 | 1.13 | B | B |
| Example 10 | 0.2 μm | 8.1 | H2O2 21g/L, H2SO4 165g/L, 35°C | 0.24 | 1.20 | 0.20 | 1.13 | A | A |
| Example 11 | 0.3 μm | 7.3 | H2O2 21g/L, H2SO4 165g/L, 35°C | 0.11 | 0.56 | 0.12 | 0.65 | AA | AA |
| Example 12 | 0.3 μm | 7.5 | H2O2 21g/L, H2SO4 165g/L, 35°C | 0.12 | 0.59 | 0.13 | 0.68 | AA | AA |

EP 3 199 652 A2

23

| | Copper foil after forming board | | Etching condition (dipping method, agitation: 100 rpm, 6 $\mu$m etching) | Surface roughness of surface of copper foil on gloss face side before etching (a) | | Surface roughness of surface of copper foil on gloss face side after 6 $\mu$m etching (b) | | Circuit formability | High frequency characteristics |
|---|---|---|---|---|---|---|---|---|---|
| | Average thickness of crystal grains | I(220)/ I0 (220) | | Ra ($\mu$m) | Rz ($\mu$m) | Ra ($\mu$m) | Rz ($\mu$m) | | |
| Example 13 | 0.2 $\mu$m | 7.8 | H2O2 21g/L, H2SO4 165g/L, 35°C | 0.13 | 0.65 | 0.14 | 0.72 | AA | AA |
| Example 14 | 0.2 $\mu$m | 8.0 | H2O2 21g/L, H2SO4 165g/L, 35°C | 0.15 | 0.67 | 0.16 | 0.76 | A | A |
| Example 15 | 0.8 $\mu$m | 3.2 | H2O2 21g/L, H2SO4 165g/L, 35°C | 0.11 | 0.55 | 0.17 | 0.81 | A | A |
| Example 16 | 0.6 $\mu$m | 3.4 | H2O2 21g/L, H2SO4 165g/L, 35°C | 0.11 | 0.55 | 0.14 | 0.71 | AA | AA |
| Example 17 | 0.1 $\mu$m | 9.3 | H2O2 21g/L, H2SO4 165g/L, 35°C | 0.08 | 0.54 | 0.10 | 0.55 | S | S |
| Example 18 | 0.1 $\mu$m | 5.6 | H2O2 21g/L, H2SO4 165g/L, 35°C | 0.08 | 0.54 | 0.11 | 0.57 | S | S |
| Example 19 | 0.2 $\mu$m | 3.2 | H2O2 21g/L, H2SO4 165g/L, 35°C | 0.08 | 0.54 | 0.12 | 0.67 | AA | AA |
| Example 20 | > 1 $\mu$m | 0.7 | H2O2 21g/L, H2SO4 165g/L, 35°C | 0.08 | 0.52 | 0.16 | 0.92 | B | B |
| Example 21 | 0.1 $\mu$m | 9.5 | H2O2 21g/L, H2SO4 165g/L, 35°C | 0.08 | 0.44 | 0.11 | 0.52 | S | S |
| Example 22 | 0.1 $\mu$m | 9.6 | H2O2 21g/L, H2SO4 165g/L, 35°C | 0.07 | 0.43 | 0.10 | 0.52 | S | S |
| Example 23 | 0.1 $\mu$m | 10.1 | H2O2 21g/L, H2SO4 165g/L, 35°C | 0.08 | 0.45 | 0.10 | 0.51 | S | S |
| Example 24 | 0.1 $\mu$m | 7.9 | H2O2 21g/L, H2SO4 165g/L, 35°C | 0.07 | 0.42 | 0.11 | 0.52 | S | S |

| | Copper foil after forming board | | Etching condition (dipping method, agitation: 100 rpm, 6 $\mu$m etching) | Surface roughness of surface of copper foil on gloss face side before etching (a) | | Surface roughness of surface of copper foil on gloss face side after 6 $\mu$m etching (b) | | Circuit formability | High frequency characteristics |
|---|---|---|---|---|---|---|---|---|---|
| | Average thickness of crystal grains | I(220)/I0 (220) | | Ra ($\mu$m) | Rz ($\mu$m) | Ra ($\mu$m) | Rz ($\mu$m) | | |
| Example 25 | 0.2 $\mu$m | 8.1 | H2O2 21g/L, H2SO4 165g/L, 35°C | 0.06 | 0.43 | 0.10 | 0.53 | S | S |
| Example 26 | 0.2 $\mu$m | 8.1 | H2O2 21g/L, H2SO4 165g/L, 35°C | 0.07 | 0.42 | 0.11 | 0.52 | S | S |
| Example 27 | 0.1 $\mu$m | 8.3 | H2O2 21g/L, H2SO4 165g/L, 35°C | 0.25 | 1.10 | 0.20 | 1.09 | A | A |
| Example 28 | 0.5 $\mu$m | 7.9 | H2O2 21g/L, H2SO4 165g/L, 35°C | 0.19 | 1.01 | 0.22 | 1.29 | B | B |
| Example 29 | 0.1 $\mu$m | 8.0 | Na2S2O8 50g/L, H2SO4 35g/L, 35°C | 0.05 | 0.35 | 0.11 | 0.49 | S | S |
| Example 30 | 0.1 $\mu$m | 7.8 | Na2S2O8 50g/L, H2SO4 35g/L, 35°C | 0.06 | 0.39 | 0.12 | 0.51 | S | S |
| Comparative Example 1 | > 5 $\mu$m | 0.3 | H2O2 21g/L, H2SO4 165g/L, 35°C | 0.11 | 0.68 | 0.25 | 1.33 | C | C |
| Comparative Example 2 | > 5 $\mu$m | 0.6 | H2O2 21g/L, H2SO4 165g/L, 35°C | 0.09 | 0.46 | 0.24 | 1.29 | C | C |
| Comparative Example 3 | > 5 $\mu$m | 0.3 | H2O2 21g/L, H2SO4 165g/L, 35°C | 0.15 | 0.72 | 0.24 | 1.03 | C | C |
| Comparative Example 4 | > 1 $\mu$m | 0.5 | H2O2 21g/L, H2SO4 165g/L, 35°C | 0.26 | 1.45 | 0.23 | 1.01 | C | C |
| Comparative Example 5 | > 5 $\mu$m | 0.5 | H2O2 21g/L, H2SO4 165g/L, 35°C | 0.09 | 0.47 | 0.23 | 1.25 | C | C |
| Comparative Example 6 | > 5 $\mu$m | 0.4 | Na2S2O8 50g/L, H2SO4 35g/L, 35°C | 0.09 | 0.55 | 0.23 | 1.32 | C | C |

EP 3 199 652 A2

(continued)

| | Copper foil after forming board | | Etching condition (dipping method, agitation: 100 rpm, 6 μm etching) | Surface roughness of surface of copper foil on gloss face side before etching (a) | | Surface roughness of surface of copper foil on gloss face side after 6 μm etching (b) | | Circuit formability | High frequency characteristics |
|---|---|---|---|---|---|---|---|---|---|
| | Average thickness of crystal grains | I(220)/ I0 (220) | | Ra (μm) | Rz (μm) | Ra (μm) | Rz (μm) | | |
| Comparative Example 7 | > 1 μm | 0.6 | Na2S2O8 50g/L, H2SO4 35g/L, 35°C | 0.24 | 1.17 | 0.26 | 1.45 | C | C |
| Comparative Example 8 | > 1 μm | 0.3 | Na2S2O8 50g/L, H2SO4 35g/L, 35°C | 0.10 | 0.64 | 0.26 | 1.37 | C | C |
| Comparative Example 9 | 2.3 μm | 0.9 | H2O2 21g/L, H2SO4 165g/L, 35°C | 0.15 | 1.35 | 0.24 | 1.39 | C | C |
| Comparative Example 10 | 0.5 μm | 3.6 | H2O2 21g/L, H2SO4 165g/L, 35°C | 0.26 | 0.30 | 0.27 | 0.34 | C | C |
| Comparative Example 11 | 1.9 μm | 1.9 | Na2S2O8 100g/L, H2SO4 35g/L, 50°C | 0.28 | 0.81 | 0.36 | 1.01 | C | C |
| Comparative Example 12 | 0.2 μm | 7.6 | H2O2 21g/L, H2SO4 165g/L, 35°C | 0.15 | 1.32 | 0.16 | 1.35 | C | C |
| Comparative Example 13 | 5.2 μm | 0.9 | H2O2 21g/L, H2SO4 165g/L, 35°C | 0.15 | 1.35 | 0.29 | 1.49 | C | C |

Evaluation Results

The copper foils of Examples 1 to 30 each were a copper foil including a gloss face, a surface roughness Ra of a surface of the copper foil on the gloss face side being 0.25 $\mu$m or less measured with a laser microscope and a surface roughness Rz of the surface of the copper foil on the gloss face side being 1.10 $\mu$m or less measured with a laser microscope, in which the copper foil has a layer structure retained after heating at 200°C for 30 minutes or after heating at 130°C for 30 minutes, or a copper foil including a gloss face, a surface roughness Ra of a surface of the copper foil on the gloss face side being 0.25 $\mu$m or less measured with a laser microscope and a surface roughness Rz of the surface of the copper foil on the gloss face side being 1.10 $\mu$m or less measured with a laser microscope of, in which the copper foil has a layer structure retained after heating at 300°C for 30 minutes. Accordingly, the copper foils of Examples 1 to 30 each had good circuit formability and good high frequency characteristics.

On the other hand, the copper foils of Comparative Examples 1 to 13 each were a copper foil , which has a gloss face, that did not satisfy a surface roughness Ra of a surface of the copper foil on the gloss face side being 0.25 $\mu$m or less measured with a laser microscope and/or a surface roughness Rz of a surface of the copper foil on the gloss face side being 1.10 $\mu$m or less measured with a laser microscope, or did not retain the layer structure after heating at 200°C for 30 minutes or after heating at 130°C for 30 minutes, a copper foil , which has a gloss face, that did not satisfy a surface roughness Ra of a surface of the copper foil on the gloss face side being 0.25 $\mu$m or less measured with a laser microscope and/or a surface roughness Rz of a surface of the copper foil on the gloss face side being 1.10 $\mu$m or less measured with a laser microscope, or did not retain the layer structure after heating 300°C for 30 minutes, a copper foil, which has a gloss face, that did not satisfy a surface roughness Ra of a surface of the copper foil on the gloss face side being 0.22 $\mu$m or less measured with a laser microscope after half-etching and/or a surface roughness Rz of the surface of the copper foil on the gloss face side being 1.30 $\mu$m or less measured with a laser microscope after half-etching, or a copper foil , which has a gloss face, that did not satisfy $I(220)/I_0(220)$ of 1 or more on the surface of the copper foil on the gloss face side after heating the copper foil at 200°C for 30 minutes, after heating at 130°C for 30 minutes, or heating at 300°C for 30 minutes. Accordingly, the copper foils of Comparative Examples 1 to 13 each had poor high frequency characteristics and poor circuit formability.

**Claims**

1. A copper foil
   comprising a gloss face, a surface roughness Ra of a surface of the copper foil on the gloss face side being 0.25 $\mu$m or less measured with a laser microscope and a surface roughness Rz of the surface of the copper foil on the gloss face side being 1.10 $\mu$m or less measured with a laser microscope,
   wherein the copper foil has a layer structure after heating at 200°C for 30 minutes or after heating at 130°C for 30 minutes or after heating at 300°C for 30 minutes.

2. The copper foil according to claim 1, wherein the copper foil satisfies one or two or more of the following conditions (1) to (5):

   (1) the copper foil having a layer structure before heating at 200°C for 30 minutes or before heating at 130°C for 30 minutes, the layer structure being retained after the heating at 200°C for 30 minutes or after the heating at 130°C for 30 minutes;
   (2) the copper foil having $I(220)/I_0(220)$ of 1 or more on the surface of the copper foil on the gloss face side after heating the copper foil at 200°C for 30 minutes or after heating at 130°C for 30 minutes;
   (3) the copper foil having a layer structure after heating at 300°C for 30 minutes;
   (4) the copper foil having a layer structure before heating at 300°C for 30 minutes, the layer structure being retained after the heating at 300°C for 30 minutes; and
   (5) the copper foil having $I(220)/I_0(220)$ of 1 or more on the surface of the copper foil on the gloss face side after heating the copper foil at 300°C for 30 minutes.

3. The copper foil according to claim 1 or 2, wherein the copper foil satisfies one or two or more of the following conditions (6) to (11):

   (6) the copper foil having a gloss face, after heating at 200°C for 30 minutes or after the heating at 130°C for 30 minutes, and then half-etching with a sulfuric acid-hydrogen peroxide etching solution, a surface roughness Ra of a surface of the copper foil on the gloss face side being 0.15 $\mu$m or less measured with a laser microscope and a surface roughness Rz of the surface of the copper foil on the gloss face side being 0.80 $\mu$m or less

measured with a laser microscope;

(7) the copper foil having a gloss face, after heating at 200°C for 30 minutes or after the heating at 130°C for 30 minutes, and then half-etching with a sodium persulfate etching solution, a surface roughness Ra of a surface of the copper foil on the gloss face side being 0.22 $\mu$m or less measured with a laser microscope and a surface roughness Rz of the surface of the copper foil on the gloss face side being 1.30 $\mu$m or less measured with a laser microscope;

(8) the copper foil having a gloss face, after heating at 300°C for 30 minutes, and then half-etching with a sulfuric acid-hydrogen peroxide etching solution, a surface roughness Ra of a surface of the copper foil on the gloss face side being 0.15 $\mu$m or less measured with a laser microscope and a surface roughness Rz of the surface of the copper foil on the gloss face side being 0.80 $\mu$m or less measured with a laser microscope;

(9) the copper foil having a gloss face, after heating at 300°C for 30 minutes, and then half-etching with a sodium persulfate etching solution, a surface roughness Ra of a surface of the copper foil on the gloss face side being 0.22 $\mu$m or less measured with a laser microscope and a surface roughness Rz of the surface of the copper foil on the gloss face side being 1.30 $\mu$m or less measured with a laser microscope;

(10) the copper foil having a gloss face, after heating at 200°C for 30 minutes or after the heating at 130°C for 30 minutes, and then half-etching with a sulfuric acid-hydrogen peroxide etching solution, a surface roughness Ra of a surface of the copper foil on the gloss face side being 0.22 $\mu$m or less measured with a laser microscope and a surface roughness Rz of the surface of the copper foil on the gloss face side being 1.30 $\mu$m or less measured with a laser microscope; and

(11) the copper foil having a gloss face, after heating at 300°C for 30 minutes, and then half-etching with a sulfuric acid-hydrogen peroxide etching solution, a surface roughness Ra of a surface of the copper foil on the gloss face side being 0.22 $\mu$m or less measured with a laser microscope and a surface roughness Rz of the surface of the copper foil on the gloss face side being 1.30 $\mu$m or less measured with a laser microscope.

4. The copper foil according to any one of claims 1 to 3,
wherein the copper foil comprises a gloss face, a surface roughness Ra of a surface of the copper foil on the gloss face side being 0.25 $\mu$m or less measured with a laser microscope and a surface roughness Rz of the surface of the copper foil on the gloss face side being 1.10 $\mu$m or less measured with a laser microscope, and
the copper foil has a layer structure before heating at 200°C for 30 minutes or before heating at 130°C for 30 minutes, the layer structure being retained after the heating at 200°C for 30 minutes or after the heating at 130°C for 30 minutes.

5. A copper foil
comprising a gloss face, a surface roughness Ra of a surface of the copper foil on the gloss face side being 0.25 $\mu$m or less measured with a laser microscope and a surface roughness Rz of the surface of the copper foil on the gloss face side being 1.10 $\mu$m or less measured with a laser microscope,
wherein the copper foil has $I(220)/I_0(220)$ of 1 or more on the surface of the copper foil on the gloss face side after heating the copper foil at 200°C for 30 minutes or after heating at 130°C for 30 minutes or after heating at 300°C for 30 minutes.

6. The copper foil according to any one of claims 1 to 5, wherein the copper foil comprises a gloss face, a surface roughness Ra of a surface of the copper foil on the gloss face side being 0.25 $\mu$m or less measured with a laser microscope and a surface roughness Rz of the surface of the copper foil on the gloss face side being 1.10 $\mu$m or less measured with a laser microscope, and
the copper foil has a layer structure after heating at 300 °C for 30 minutes.

7. The copper foil according to any one of claims 1 to 6,
wherein the copper foil comprises a gloss face, a surface roughness Ra of a surface of the copper foil on the gloss face side being 0.25 $\mu$m or less measured with a laser microscope and a surface roughness Rz of the surface of the copper foil on the gloss face side being 1.10 $\mu$m or less measured with a laser microscope, and
the copper foil has a layer structure before heating at 300°C for 30 minutes, the layer structure being retained after the heating at 300°C for 30 minutes.

8. The copper foil according to any one of claims 1 to 7,
wherein the copper foil comprises a gloss face, a surface roughness Ra of a surface of the copper foil on the gloss face side being 0.25 $\mu$m or less measured with a laser microscope and a surface roughness Rz of the surface of the copper foil on the gloss face side being 1.10 $\mu$m or less measured with a laser microscope, and
the copper foil has $I(220)/I_0(220)$ of 1 or more on the surface of the copper foil on the gloss face side after heating the copper foil at 300°C for 30 minutes.

9. A copper foil
comprising a gloss face, after heating at 200°C for 30 minutes or after the heating at 130°C for 30 minutes or after the heating at 300°C for 30 minutes, and then half-etching with a sulfuric acid-hydrogen peroxide etching solution or a sodium persulfate etching solution, a surface roughness Ra of a surface of the copper foil on the gloss face side being 0.22 μm or less measured with a laser microscope and a surface roughness Rz of the surface of the copper foil on the gloss face side being 1.30 μm or less measured with a laser microscope.

10. The copper foil according to any one of claims 1 to 9,
wherein the copper foil comprises a gloss face, after heating at 200°C for 30 minutes or after the heating at 130°C for 30 minutes, and then half-etching with a sulfuric acid-hydrogen peroxide etching solution, a surface roughness Ra of a surface of the copper foil on the gloss face side being 0.22 μm or less measured with a laser microscope and a surface roughness Rz of the surface of the copper foil on the gloss face side being 1.30 μm or less measured with a laser microscope.

11. The copper foil according to any one of claims 1 to 10,
wherein the copper foil comprises a gloss face, after heating at 200°C for 30 minutes or after the heating at 130°C for 30 minutes, and then half-etching with a sulfuric acid-hydrogen peroxide etching solution, a surface roughness Ra of a surface of the copper foil on the gloss face side being 0.15 μm or less measured with a laser microscope and a surface roughness Rz of the surface of the copper foil on the gloss face side being 0.80 μm or less measured with a laser microscope.

12. The copper foil according to any one of claims 1 to 11,
wherein the copper foil comprises a gloss face, after heating at 200°C for 30 minutes or after the heating at 130°C for 30 minutes, and then half-etching with a sodium persulfate etching solution, a surface roughness Ra of a surface of the copper foil on the gloss face side being 0.22 μm or less measured with a laser microscope and a surface roughness Rz of the surface of the copper foil on the gloss face side being 1.30 μm or less measured with a laser microscope.

13. The copper foil according to any one of claims 1 to 12,
wherein the copper foil comprises a gloss face, after heating at 300°C for 30 minutes, and then half-etching with a sulfuric acid-hydrogen peroxide etching solution, a surface roughness Ra of a surface of the copper foil on the gloss face side being 0.22 μm or less measured with a laser microscope and a surface roughness Rz of the surface of the copper foil on the gloss face side being 1.30 μm or less measured with a laser microscope.

14. The copper foil according to any one of claims 1 to 13,
wherein the copper foil comprises a gloss face, after heating at 300°C for 30 minutes, and then half-etching with a sulfuric acid-hydrogen peroxide etching solution, a surface roughness Ra of a surface of the copper foil on the gloss face side being 0.15 μm or less measured with a laser microscope and a surface roughness Rz of the surface of the copper foil on the gloss face side being 0.80 μm or less measured with a laser microscope.

15. The copper foil according to any one of claims 1 to 14,
wherein the copper foil comprises a gloss face, after heating at 300°C for 30 minutes, and then half-etching with a sodium persulfate etching solution, a surface roughness Ra of a surface of the copper foil on the gloss face side being 0.22 μm or less measured with a laser microscope and a surface roughness Rz of the surface of the copper foil on the gloss face side being 1.30 μm or less measured with a laser microscope.

16. The copper foil according to any one of claims 1 to 15,
wherein the copper foil satisfies at least one of the following conditions (12) to (15):

(12) the copper foil having, after heating at 200°C for 30 minutes or 130°C for 30 minutes and half-etching with a sulfuric acid-hydrogen peroxide etching solution, a surface roughness Ra of a surface of the copper foil on the gloss face side and a surface roughness Rz of the surface of the copper foil on the gloss face side measured with a laser microscope, satisfying the following condition (12-1) or (12-2):

(12-1) the surface roughness Ra of the surface of the copper foil on the gloss face side is 0.22 μm or less and the surface roughness Rz of the surface of the copper foil on the gloss face side is 1.30 μm or less,
(12-2) the surface roughness Ra of the surface of the copper foil on the gloss face side is 0.15 μm or less and the surface roughness Rz of the surface of the copper foil on the gloss face side is 0.80 μm or less;

(13) the copper foil having, after heating at 200°C for 30 minutes or 130°C for 30 minutes and half-etching with a sodium persulfate etching solution, a surface roughness Ra of a surface of the copper foil on the gloss face side being 0.22 $\mu$m or less measured with a laser microscope and a surface roughness Rz of the surface of the copper foil on the gloss face side being 1.30 $\mu$m or less measured with a laser microscope;

(14) the copper foil having, after heating at 300°C for 30 minutes and half-etching with a sulfuric acid-hydrogen peroxide etching solution, a surface roughness Ra of a surface of the copper foil on the gloss face side and a surface roughness Rz of the surface of the copper foil on the gloss face side measured with a laser microscope, satisfying the following condition (14-1) or (14-2):

(14-1) the surface roughness Ra of the surface of the copper foil on the gloss face side is 0.22 $\mu$m or less and the surface roughness Rz of the surface of the copper foil on the gloss face side is 1.30 $\mu$m or less,

(14-2) the surface roughness Ra of the surface of the copper foil on the gloss face side is 0.15 $\mu$m or less and the surface roughness Rz of the surface of the copper foil on the gloss face side is 0.80 $\mu$m or less;

(15) the copper foil having, after heating at 300°C for 30 minutes and half-etching with a sodium persulfate etching solution, a surface roughness Ra of a surface of the copper foil on the gloss face side being 0.22 $\mu$m or less measured with a laser microscope and a surface roughness Rz of the surface of the copper foil on the gloss face side being 1.30 $\mu$m or less measured with a laser microscope.

17. The copper foil according to any one of claims 3, 9 to 16, wherein a thickness of the copper foil that is removed by the half-etching is 6 $\mu$m or a half of a thickness before the half-etching.

18. The copper foil according to any one of claims 1 to 17, satisfying at least one of the following conditions (16) to (21) :

(16) an average thickness of the crystal grains of the copper foil, before heating at 200°C for 30 minutes, is 0.05 to 1.0 $\mu$m;
(17) an average thickness of the crystal grains of the copper foil, before heating at 130°C for 30 minutes, is 0.05 to 1.0 $\mu$m;
(18) an average thickness of the crystal grains of the copper foil, before heating at 300°C for 30 minutes, is 0.05 to 1.0 $\mu$m;
(19) an average thickness of the crystal grains of the copper foil, after heating at 200°C for 30 minutes, is 0.001 to 1.0 $\mu$m;
(20) an average thickness of the crystal grains of the copper foil, after heating at 130°C for 30 minutes, is 0.001 to 1.0 $\mu$m;
(21) an average thickness of the crystal grains of the copper foil, after heating at 300°C for 30 minutes, is 0.001 to 1.0 $\mu$m.

19. The copper foil according to any one of claims 1 to 18, satisfying at least one of the following conditions (22) to (24) :

(22) an area ratio of a layer structure of the copper foil, after heating at 200°C for 30 minutes, is 10% or more;
(23) an area ratio of a layer structure of the copper foil, after heating at 130°C for 30 minutes, is 10% or more;
(24) an area ratio of a layer structure of the copper foil, after heating at 300°C for 30 minutes, is 10% or more.

20. The copper foil according to any one of claims 1 to 19, wherein a concentration of element in the copper foil in terms of the total amount of the one or more elements selected from the group consisting of Sn, Ag, In, Au, Pd, P, Ti, B, V, Cr, Fe, Zr, Mn, Mo, Co, Ni, Zn, Si, C, W, As, Ca, Al, Cl, Be, N, S, F, Sr, Ba, Sc, Y, Ga, Ge, Se, Br, Nb, Ta, Ru, Rh, Cd, Sb, Bi, I, and Mg is 10 ppm by mass or more.

21. The copper foil according to any one of claims 1 to 20, wherein the copper foil is a rolled copper foil.

22. The copper foil according to any one of claims 1 to 21, wherein the copper foil is for attaching to a resin having a dielectric constant of 3.5 or less.

23. The copper foil according to any one of claims 1 to 21, wherein the copper foil is for attaching to a liquid crystal polymer or a fluorine resin or a low induction polyimide resin.

24. The copper foil according to any one of claims 1 to 23, wherein the copper foil is used in a copper-clad laminate board or a printed wiring board that is used under a high frequency exceeding 1 GHz.

25. The copper foil according to any one of claims 1 to 24, wherein the copper foil has $I(220)/I_0(220)$ of 1 or more on the surface of the copper foil on the gloss face side after the heating.

26. The copper foil according to any one of claims 1 to 25, satisfying at least one of the following conditions (25-1) to (25-10):

(25-1) the copper foil contains, on a surface of the copper foil, one or more layers selected from the group consisting of a roughening treatment layer, a heat resistance treatment layer, a rust prevention treatment layer, a chromate treatment layer, and a silane coupling treatment layer;

(25-2) the copper foil contains, on a surface of the copper foil, one or more layers selected from the group consisting of a heat resistance treatment layer, a rust prevention treatment layer, a chromate treatment layer, and a silane coupling treatment layer;

(25-3) the copper foil contains a heat resistance treatment layer or a rust prevention treatment layer on a surface of the copper foil, contains a chromate treatment layer on the heat resistance treatment layer or the rust prevention treatment layer, and contains a silane coupling treatment layer on the chromate treatment layer;

(25-4) the copper foil contains a heat resistance treatment layer on a surface of the copper foil, contains a rust prevention treatment layer on the heat resistance treatment layer, contains a chromate treatment layer on the rust prevention treatment layer, and contains a silane coupling treatment layer on the chromate treatment layer;

(25-5) the copper foil contains a chromate treatment layer on a surface of the copper foil, and contains a silane coupling treatment layer on the chromate treatment layer;

(25-6) the copper foil contains a roughening treatment layer on a surface of the copper foil, contains a chromate treatment layer on the roughening treatment layer, and contains a silane coupling treatment layer on the chromate treatment layer;

(25-7) the copper foil contains a roughening treatment layer on a surface of the copper foil, contains one or more layers selected from the group consisting of a rust prevention treatment layer and a heat resistance treatment layer on the roughening treatment layer, contains a chromate treatment layer on the one or more layers selected from the group consisting of a rust prevention treatment layer and a heat resistance treatment layer, and contains a silane coupling treatment layer on the chromate treatment layer;

(25-8) the copper foil contains a roughening treatment layer on a surface of the copper foil, contains a rust prevention treatment layer on the roughening treatment layer, contains a chromate treatment layer on the rust prevention treatment layer, and contains a silane coupling treatment layer on the chromate treatment layer;

(25-9) the copper foil contains a roughening treatment layer on a surface of the copper foil, and contains a silane coupling treatment layer on the roughening treatment layer;

(25-10) the copper foil contains a silane coupling treatment layer on a surface of the copper foil.

27. A copper-clad laminate board comprising the copper foil according to any one of claims 1 to 26 and an insulating substrate that are adhered to each other.

28. A copper-clad laminate board comprising the copper foil according to any one of claims 1 to 26 and an insulating substrate having a dielectric constant of 3.5 or less, being laminated to the copper foil.

29. The copper-clad laminate board according to claim 27 or 28, wherein the copper-clad laminate board is used under a high frequency exceeding 1 GHz.

30. A copper-clad laminate board comprising a copper foil and an insulating substrate that are adhered to each other, satisfying at least one of the following conditions (26-1) to (26-6) :

(26-1) the copper foil has a layer structure,
wherein the copper foil has a surface roughness Ra of a surface of the copper foil on the gloss face side being 0.25 $\mu$m or less measured with a laser microscope and a surface roughness Rz of the surface of the copper foil on the gloss face side being 1.10 $\mu$m or less measured with a laser microscope , and
wherein the copper-clad laminate board has a substrate dielectric constant of 3.5 or less;
(26-2) the copper foil has a gloss face, $I(220)/I_0(220)$ of 1 or more on a surface of the copper foil on the gloss face sideafter adhering to the insulating substrate,
wherein the copper foil has a surface roughness Ra of a surface of the copper foil on the gloss face side being 0.25 $\mu$m or less measured with a laser microscope and a surface roughness Rz of the surface of the copper foil on the gloss face side being 1.10 $\mu$m or less measured with a laser microscope, and
wherein the copper-clad laminate board has a substrate dielectric constant of 3.5 or less;

(26-3) the copper foil has a gloss face, after half-etching with a sulfuric acid-hydrogen peroxide etching solution, a surface roughness Ra of a surface of the copper foil on the gloss face side and a surface roughness Rz of the surface of the copper foil on the gloss face side measured with a laser microscope, satisfying the following condition (26-3-1) or (26-3-2):

(26-3-1) the surface roughness Ra of the surface of the copper foil on the gloss face side is 0.22 $\mu$m or less and the surface roughness Rz of the surface of the copper foil on the gloss face side is 1.30 $\mu$m or less;
(26-3-2) the surface roughness Ra of the surface of the copper foil on the gloss face side is 0.15 $\mu$m or less and the surface roughness Rz of the surface of the copper foil on the gloss face side is 0.80 $\mu$m or less;

(26-4) the copper foil has a gloss face, after half-etching with a sodium persulfate etching solution, a surface roughness Ra of a surface of the copper foil on the gloss face side being 0.22 $\mu$m or less measured with a laser microscope and a surface roughness Rz of the surface of the copper foil on the gloss face side being 1.30 $\mu$m or less measured with a laser microscope;
(26-5) an average thickness of the crystal grains of the copper foil is 0.001 to 1.0 $\mu$m and satisfying at least one of the conditions (26-1) to (26-4);
(26-6) an area ratio of a layer structure of the copper foil is 10% or more and satisfying at least one of the conditions (26-1) to (26-5).

31. A method for producing a printed wiring board, comprising using the copper-clad laminate board according to any one of claims 27 to 30.

32. A method for producing an electronic apparatus, comprising using a printed wiring board produced by the production method according to claim 31.

33. A method for producing a transmission channel, comprising using the copper-clad laminate board according to claim 27 to 30 or using a printed wiring board produced by the production method according to claim 31, the transmission channel being used under a high frequency exceeding 1 GHz.

34. A method for producing an antenna, comprising using the copper-clad laminate board according to claim 27 to 30 or using a printed wiring board produced by the production method according to claim 31, the antenna being used under a high frequency exceeding 1 GHz.

Figure 1

**REFERENCES CITED IN THE DESCRIPTION**

**Patent documents cited in the description**

- JP 4161304 B
- JP 4704025 B
- JP 2004244656 A